# EUROPEAN PATENT SPECIFICATION

(11) **EP 4 509 733 B1**
(45) Date of publication and mention of the grant of the patent: **20.05.2026**
(21) Application number: 24767984.8
(22) Date of filing: 01.03.2024
(51) Int. Cl.: F16C 11/04, G06F 1/16, H04M 1/02, E05D 3/12

(54) **HINGE AND FOLDABLE DEVICE**
SCHARNIER UND KLAPPBARE VORRICHTUNG
CHARNIÈRE ET DISPOSITIF PLIABLE

(30) Priority: 26.06.2023 CN 202310760828
(43) Date of publication of application: 19.02.2025
(73) Proprietor: HUAWEI TECHNOLOGIES CO., LTD., Shenzhen, Guangdong 518129 (CN)
(72) Inventor: LI, Kaixu, Shenzhen, Guangdong 518129 (CN); XIAO, Zhenlin, Shenzhen, Guangdong 518129 (CN); ZHONG, Ding, Shenzhen, Guangdong 518129 (CN); FAN, Wen, Shenzhen, Guangdong 518129 (CN)
(74) Representative: Pfenning, Meinig & Partner mbB
(86) International application number: PCT/CN2024/079735
(87) International publication number: WO 2025/001266

(56) References cited:
- CN-A- 113 795 683
- CN-A- 114 095 592
- CN-A- 114 449 068
- CN-A- 115 750 580
- CN-A- 116 085 377
- CN-A- 116 123 207
- CN-U- 218 886 760
- TW-A- 201 339 442
- US-A1- 2021 037 664

## Description

### TECHNICAL FIELD

This application relates to the field of electronic device technologies, and in particular, to a hinge for a foldable device and a foldable device.

### BACKGROUND

A foldable device usually includes two separate housings, and the two housings may be connected through a hinge, to implement a folding function. When a user needs to carry the foldable device, the user may fold the foldable device, to reduce an area of the foldable device, thereby improving portability. When the user needs to use the foldable device, the user may unfold the foldable device, to provide a larger display area and operation area, thereby improving use convenience.

Currently, a hinge in a foldable device has a large quantity of components, which increases manufacturing difficulty and assembly difficulty, significantly increases manufacturing costs of the foldable device, and is not conducive to ensuring reliability of the hinge. In addition, in a process in which the foldable device is folded or unfolded, a contact area between a kinematic pair is small, which is not conducive to ensuring stability during motion.

CN 113795683 A discloses a rotation shaft structure, which includes a main shaft assembly, and a first folding assembly and a second folding assembly that are symmetrically disposed with respect to the main shaft assembly.

### SUMMARY

This application provides a hinge for a foldable device that has a simple structure and good motion stability and a foldable device. The invention is set out in the appended set of claims.

According to a first aspect, this application provides a hinge for a foldable device. The hinge may include a main shaft, a first folding component, and a second folding component. The first folding component and the second folding component are disposed on two sides of the main shaft. The first folding component and the second folding component can rotate relative to the main shaft, to implement a folding function of the hinge. The first folding component may include a first rotating part and a first embedded shaft. The first embedded shaft is rotatably connected to the main shaft, the first rotating part is rotatably connected to the first embedded shaft, and a rotation axis center of the first rotating part coincides with a rotation axis center of the first embedded shaft, so that the first rotating part can be rotatably connected to the main shaft. In addition, the second folding component includes a second rotating part and a second embedded shaft. The second embedded shaft is rotatably connected to the main shaft, the second rotating part is rotatably connected to the second embedded shaft, and a rotation axis center of the second rotating part coincides with a rotation axis center of the second embedded shaft, so that the second rotating part can be rotatably connected to the main shaft. The main shaft has a first arc-shaped surface, the first embedded shaft has a second arc-shaped surface, and the first arc-shaped surface contacts the second arc-shaped surface, so that the first embedded shaft is rotatably connected to the main shaft. The first rotating part has a third arc-shaped surface, the first embedded shaft has a fourth arc-shaped surface, and the third arc-shaped surface contacts the fourth arc-shaped surface, so that the first rotating part is rotatably connected to the first embedded shaft. An axis center of the first arc-shaped surface, an axis center of the second arc-shaped surface, an axis center of the third arc-shaped surface, and an axis center of the fourth arc-shaped surface all coincide with each other, so that the rotation axis center of the first rotating part coincides with the rotation axis center of the first embedded shaft. The second folding component includes the second rotating part and the second embedded shaft. The second rotating part may be connected to the main shaft through the second embedded shaft. Specifically, the main shaft has a fifth arc-shaped surface, the second embedded shaft has a sixth arc-shaped surface, and the fifth arc-shaped surface contacts the sixth arc-shaped surface, so that the second embedded shaft is rotatably connected to the main shaft. The second rotating part has a seventh arc-shaped surface, the second embedded shaft has an eighth arc-shaped surface, and the seventh arc-shaped surface contacts the eighth arc-shaped surface, so that the second rotating part is rotatably connected to the second embedded shaft. An axis center of the fifth arc-shaped surface, an axis center of the sixth arc-shaped surface, an axis center of the seventh arc-shaped surface, and an axis center of the eighth arc-shaped surface all coincide with each other, so that the rotation axis center of the second rotating part coincides with the rotation axis center of the second embedded shaft.

The hinge provided in this application may be assembled by using the first rotating part, the second rotating part, the main shaft, the first embedded shaft, and the second embedded shaft, so that the hinge has a good folding function, and has advantages of fewer components and a simple structure. The first rotating part may be rotatably connected to the main shaft through the first embedded shaft. The first rotating part and the first embedded shaft may form a kinematic pair, and the third arc-shaped surface contacts the fourth arc-shaped surface, so that there is a large contact area between the first rotating part and the first embedded shaft. Therefore, stability of the first rotating part and the first embedded shaft during relative motion can be improved. The first embedded shaft and the main shaft may form a kinematic pair, and the first arc-shaped surface contacts the second arc-shaped surface, so that there is a large contact area between the first embedded shaft and the main shaft. Therefore, stability of the first embedded shaft and the main shaft during relative motion can be improved. Correspondingly, the second rotating part may be rotatably connected to the main shaft through the second embedded shaft. The second rotating part and the second embedded shaft may form a kinematic pair, and the seventh arc-shaped surface contacts the eighth arc-shaped surface, so that there is a large contact area between the second rotating part and the second embedded shaft. Therefore, stability of the second rotating part and the second embedded shaft during relative motion can be improved. The second embedded shaft and the main shaft may form a kinematic pair, and the fifth arc-shaped surface contacts the sixth arc-shaped surface, so that there is a large contact area between the second embedded shaft and the main shaft. Therefore, stability of the second embedded shaft and the main shaft during relative motion can be improved.

In an example, the first rotating part may further be directly rotatably connected to the main shaft, and the second rotating part may further be directly rotatably connected to the main shaft. In other words, the first rotating part may be rotatably connected to the main shaft through the first embedded shaft, so that stability when the first rotating part and the main shaft rotate relative to each other can be effectively ensured. In addition, the first rotating part may further be directly rotatably connected to the main shaft, so that stability when the first rotating part and the main shaft rotate relative to each other can be further improved. Correspondingly, the second rotating part may be rotatably connected to the main shaft through the second embedded shaft, so that stability when the second rotating part and the main shaft rotate relative to each other can be effectively ensured. In addition, the second rotating part may further be directly rotatably connected to the main shaft, so that stability when the second rotating part and the main shaft rotate relative to each other can be further improved.

The first rotating part may have a first auxiliary arc-shaped surface, the main shaft may have a second auxiliary arc-shaped surface, the first auxiliary arc-shaped surface contacts the second auxiliary arc-shaped surface, and an axis center of the first auxiliary arc-shaped surface, the axis center of the first arc-shaped surface, and an axis center of the second auxiliary arc-shaped surface all coincide with each other. The second rotating part may have a third auxiliary arc-shaped surface, the main shaft may have a fourth auxiliary arc-shaped surface, the third auxiliary arc-shaped surface contacts the fourth auxiliary arc-shaped surface, and an axis center of the third auxiliary arc-shaped surface, the axis center of the third arc-shaped surface, and an axis center of the fourth auxiliary arc-shaped surface all coincide with each other. In general, the first rotating part may be rotatably connected to the main shaft through an arc-shaped surface, so that a contact area between the first rotating part and the main shaft can be effectively increased, and connection stability between the first rotating part and the main shaft is improved. Correspondingly, the second rotating part may be rotatably connected to the main shaft through an arc-shaped surface, so that a contact area between the second rotating part and the main shaft can be effectively increased, and connection stability between the second rotating part and the main shaft is improved.

During specific disposition, the main shaft may have a first arc-shaped slot, the first embedded shaft has a first arc-shaped arm, and the first arc-shaped arm is slidably disposed in the first arc-shaped slot. The first arc-shaped surface is located on an inner wall of the first arc-shaped slot, and the second arc-shaped surface is located on an outer surface of the first arc-shaped arm, so that the first embedded shaft is rotatably connected to the main shaft.

In addition, the first rotating part may have a second arc-shaped arm, the first embedded shaft may further have a second arc-shaped slot, and the second arc-shaped arm is slidably disposed in the second arc-shaped slot. The third arc-shaped surface is located on an outer surface of the second arc-shaped arm, and the fourth arc-shaped surface is located on an inner wall of the second arc-shaped slot, so that the first embedded shaft is rotatably connected to the first rotating part. An axis center of the first arc-shaped arm, an axis center of the first arc-shaped slot, an axis center of the second arc-shaped arm, and an axis center of the second arc-shaped slot all coincide with each other, so that it can be ensured that the first rotating part can rotate smoothly relative to the main shaft.

The first embedded shaft is rotatably connected to the first rotating part through contact between arc-shaped surfaces, so that there is a large contact area between the first embedded shaft and the first rotating part, and motion stability and force strength between the first embedded shaft and the first rotating part can be improved. Correspondingly, the first embedded shaft is rotatably connected to the main shaft through contact between arc-shaped surfaces, so that there is a large contact area between the first embedded shaft and the main shaft, and motion stability and force strength between the first embedded shaft and the main shaft can be improved.

In addition, the main shaft may further have a third arc-shaped slot, the second embedded shaft may have a third arc-shaped arm, and the third arc-shaped arm is slidably disposed in the third arc-shaped slot. The fifth arc-shaped surface is located on an inner wall of the third arc-shaped slot, and the sixth arc-shaped surface is located on an outer surface of the third arc-shaped arm, so that the second embedded shaft is rotatably connected to the main shaft.

The second rotating part may have a fourth arc-shaped arm, the second embedded shaft may further have a fourth arc-shaped slot, the fourth arc-shaped arm is slidably disposed in the fourth arc-shaped slot, the seventh arc-shaped surface is located on an outer surface of the fourth arc-shaped arm, and the eighth arc-shaped surface is located on an inner wall of the fourth arc-shaped slot, so that the second embedded shaft is rotatably connected to the main shaft. An axis center of the third arc-shaped arm, an axis center of the third arc-shaped slot, an axis center of the fourth arc-shaped arm, and an axis center of the fourth arc-shaped slot all coincide with each other, so that it can be ensured that the second rotating part can rotate smoothly relative to the main shaft.

The second embedded shaft is rotatably connected to the second rotating part through contact between arc-shaped surfaces, so that there is a large contact area between the second embedded shaft and the second rotating part, and motion stability and force strength between the second embedded shaft and the second rotating part can be improved. Correspondingly, the second embedded shaft is rotatably connected to the main shaft through contact between arc-shaped surfaces, so that there is a large contact area between the second embedded shaft and the main shaft, and motion stability and force strength between the second embedded shaft and the main shaft can be improved.

In an example, the first rotating part may further have a fifth arc-shaped arm, the fifth arc-shaped arm is slidably disposed in the first arc-shaped slot, the first auxiliary arc-shaped surface is located on an outer surface of the fifth arc-shaped arm, and the second auxiliary arc-shaped surface is located on the inner wall of the first arc-shaped slot, so that the first rotating part is rotatably connected to the main shaft. The first rotating part is rotatably connected to the main shaft through contact between arc-shaped surfaces, so that there is a large contact area between the first rotating part and the main shaft, and motion stability and force strength between the first rotating part and the main shaft can be improved.

In addition, the second rotating part may further have a sixth arc-shaped arm, the sixth arc-shaped arm is slidably disposed in the third arc-shaped slot, the third auxiliary arc-shaped surface is located on an outer surface of the sixth arc-shaped arm, and the fourth auxiliary arc-shaped surface is located on the inner wall of the third arc-shaped slot, so that the second rotating part is rotatably connected to the main shaft. The second rotating part is rotatably connected to the main shaft through contact between arc-shaped surfaces, so that there is a large contact area between the second rotating part and the main shaft, and motion stability and force strength between the second rotating part and the main shaft can be improved.

In an example, the first rotating part may have a first pressing surface, and the first embedded shaft may have a second pressing surface. When the first pressing surface presses against the second pressing surface, the first rotating part is used to drive the first embedded shaft to slide in a direction of detaching from the first arc-shaped slot, so that the first rotating part has a large rotation angle range. The main shaft has a first limiting surface, the first embedded shaft has a second limiting surface, and when the first limiting surface presses against the second limiting surface, the first embedded shaft is prevented from sliding in the direction of detaching from the first arc-shaped slot, so that the first embedded shaft can be prevented from detaching from the main shaft, and reliability of the hinge is ensured.

In addition, the second rotating part may further have a third pressing surface, and the second embedded shaft may have a fourth pressing surface. When the third pressing surface presses against the fourth pressing surface, the second rotating part is used to drive the second embedded shaft to slide in a direction of detaching from the third arc-shaped slot, so that the second rotating part has a large rotation angle range. The main shaft has a third limiting surface, the second embedded shaft has a fourth limiting surface, and when the third limiting surface presses against the fourth limiting surface, the second embedded shaft is prevented from sliding in the direction of detaching from the third arc-shaped slot, so that the second embedded shaft can be prevented from detaching from the main shaft, and reliability of the hinge is ensured.

In an example, in a direction perpendicular to a tangent of the second arc-shaped surface, a cross section of the first embedded shaft is of an I shape. The first embedded shaft has two second arc-shaped surfaces, and the two second arc-shaped surfaces are respectively located on two opposite surfaces of the first embedded shaft. The first embedded shaft has two second arc-shaped slots, and the two second arc-shaped slots are respectively located on two opposite sides of the first embedded shaft. In a direction perpendicular to a tangent of the fourth arc-shaped surface, a cross section of the second embedded shaft is of an I shape. The second embedded shaft has two fourth arc-shaped surfaces, and the two fourth arc-shaped surfaces are respectively located on two opposite surfaces of the second embedded shaft. The second embedded shaft has two fourth arc-shaped slots, and the two fourth arc-shaped slots are respectively located on two opposite sides of the second embedded shaft.

In an example, the first rotating part may have two second arc-shaped arms, the two second arc-shaped arms are disposed opposite to each other, and the first embedded shaft is clamped between the two second arc-shaped arms. The second rotating part may have two fourth arc-shaped arms, the two fourth arc-shaped arms are disposed opposite to each other, and the second embedded shaft is clamped between the two fourth arc-shaped arms.

During specific disposition, the fifth arc-shaped arm may have a first protruding part that extends in an axial direction of the fifth arc-shaped arm, the first embedded shaft has a second protruding part that extends in an axial direction of the first embedded shaft, the first pressing surface is located on a side surface that is of the first protruding part and that faces the second protruding part, and the second pressing surface is located on a side surface that is of the second protruding part and that faces the first protruding part. Correspondingly, the sixth arc-shaped arm may have a third protruding part that extends in an axial direction of the sixth arc-shaped arm, the second embedded shaft has a fourth protruding part that extends in an axial direction of the second embedded shaft, the third pressing surface is located on a side surface that is of the third protruding part and that faces the fourth protruding part, and the fourth pressing surface is located on a side surface that is of the fourth protruding part and that faces the third protruding part.

During specific disposition, the second arc-shaped surface of the first embedded shaft may have a first concave part, the second limiting surface is located on an inner wall that is of the first concave part and that faces an opening of the first arc-shaped slot, the first arc-shaped surface has a first protrusion that extends into the first concave part, and the first limiting surface is located on a side wall that is of the first protrusion and that faces the second limiting surface. Correspondingly, the sixth arc-shaped surface of the second embedded shaft may have a second concave part, the fourth limiting surface is located on an inner wall that is of the second concave part and that faces an opening of the third arc-shaped slot, the fifth arc-shaped surface has a second protrusion that extends into the second concave part, and the third limiting surface is located on a side wall that is of the second protrusion and that faces the fourth limiting surface.

In an example, concave surfaces of the first arc-shaped surface, the second arc-shaped surface, the third arc-shaped surface, the fourth arc-shaped surface, the fifth arc-shaped surface, the sixth arc-shaped surface, the seventh arc-shaped surface, and the eighth arc-shaped surface are all disposed facing a flexible display. Alternatively, it may be understood that after the concave surfaces of the arc-shaped surfaces are disposed facing the flexible display, the hinge has a function of folding outward. After the hinge is in a folded state, the hinge can be located on an inner side of the flexible display.

In an example, the main shaft may have a support surface for supporting the flexible display, and the support surface is U-shaped or elliptical. In a process in which the foldable display is folded or unfolded, the supporting surface can effectively support the flexible display. In addition, the support surface does not have an adverse impact such as an obstacle on normal bending of the flexible display.

In an example, the first rotating part may have a first support surface for supporting the flexible display, the second rotating part may have a second support surface for supporting the flexible display, and when the hinge is in an unfolded state, both the first support surface and the second support surface are located in a same plane, so that flatness of the flexible display can be ensured.

In an example, when the hinge is in the unfolded state, the support surface may not be higher than a reference plane. To be specific, a distance between the support surface and a back surface of the flexible display may be greater than distances between the first support surface and the second support surface, and the back surface of the flexible display, so that there is sufficient moving space between the support surface and the flexible display.

In an example, the hinge may further include a synchronization component, and the synchronization component includes a first synchronization part and a second synchronization part. One end of the first synchronization part is slidably connected to the first rotating part, the other end of the first synchronization part is rotatably connected to the main shaft, and a rotation axis center of the first synchronization part is parallel to a rotation axis center of the first rotating part. One end of the second synchronization part is slidably connected to the second rotating part, the other end of the second synchronization part is rotatably connected to the main shaft, and a rotation axis center of the second synchronization part is parallel to a rotation axis center of the second rotating part. The first synchronization part has a first gear part, the second synchronization part has a second gear part, and the first gear part meshes with the second gear part. Based on the synchronization component, the first rotating part and the second rotating part can rotate toward or against each other at a same speed, so that stability of the hinge in a process in which the hinge is folded or unfolded can be improved.

According to a second aspect, this application further provides a foldable device. The foldable device may include a first housing, a second housing, and a flexible display, and further includes the hinge described above. The first housing is fastened to a first rotating part, and the second housing is fastened to a second rotating part. A first part of the flexible display is fastened to the first housing, and a second part of the flexible display is fastened to the second housing.

When the hinge described above is used, a quantity of used parts of the foldable device can be effectively reduced. In addition, the foldable device also has good stability in a process in which the foldable device is unfolded or folded, so that smoothness and force stability during folding or unfolding is ensured. In addition, the first rotating part may be fastened to the first housing, and the second rotating part may be fastened to the second housing, so that the foldable device has advantages of a simple connection structure and high reliability.

In an example, a distance between a neutral layer of the flexible display and each of a rotation axis center of the first rotating part and the first embedded shaft and a rotation axis center of the second rotating part and the second embedded shaft may be less than or equal to 1 mm. When the distances between the rotation axis centers of the first rotating part, the second rotating part, the first embedded shaft, and the second embedded shaft, and the neutral layer of the flexible display are small, constant management of the flexible display is facilitated. In a process in which the foldable device is folded or unfolded, the flexible display is not easily subject to tensile stress or extrusion stress, so that security of the flexible display is improved.

### BRIEF DESCRIPTION OF DRAWINGS

FIG. 1 is a diagram of a three-dimensional structure of a mobile phone in an unfolded state according to an embodiment of this application;
FIG. 2 is a diagram of a three-dimensional structure of a mobile phone in a folded state according to an embodiment of this application;
FIG. 3 is a diagram of a three-dimensional structure of a hinge according to an embodiment of this application;
FIG. 4 is a diagram of an exploded structure of a hinge according to an embodiment of this application;
FIG. 5 is a diagram of a partial structure of a hinge according to an embodiment of this application;
FIG. 6 is a diagram of a partial exploded structure of a hinge according to an embodiment of this application;
FIG. 7 is a diagram of a partial structure of a hinge according to an embodiment of this application;
FIG. 8 is a diagram of a partial structure of a hinge according to an embodiment of this application;
FIG. 9 is a diagram of a partial structure of a hinge according to an embodiment of this application;
FIG. 10 is a diagram of a partial exploded structure of a hinge according to an embodiment of this application;
FIG. 11 is a diagram of a cross-sectional structure of a hinge in a folded state according to an embodiment of this application;
FIG. 12 is a diagram of a cross-sectional structure of a hinge in an unfolded state according to an embodiment of this application;
FIG. 13 is a diagram of an exploded structure of a foldable device in an unfolded state according to an embodiment of this application;
FIG. 14 is a diagram of an exploded structure of a foldable device in a folded state according to an embodiment of this application;
FIG. 15 is a diagram of a partial cross-sectional structure of a foldable device in an unfolded state according to an embodiment of this application; and
FIG. 16 is a diagram of a partial cross-sectional structure of a foldable device in a folded state according to an embodiment of this application.

### DESCRIPTION OF EMBODIMENTS

To make objectives, technical solutions, and advantages of this application clearer, the following further describes this application in detail with reference to accompanying drawings.

To facilitate understanding of a hinge provided in embodiments of this application, the following first describes an application scenario of the hinge.

The hinge provided in embodiments of this application can be used in a foldable device. The foldable device is specifically an electronic device that can change a form of the electronic device in a manner of folding, rotation, or the like. Under different use requirement conditions, a user may fold or unfold the foldable device to meet different user requirements.

For example, when the user needs to carry the foldable device, the user may fold the foldable device, to reduce a volume of the foldable device, thereby improving portability. When the user needs to use the foldable device, the user may unfold the foldable device, to provide a larger display area and operation area, thereby improving use convenience. In an actual application, the foldable device may be classified into a plurality of types. For example, the foldable device may be specifically a mobile phone, a tablet computer, a notebook computer, an electronic book, or the like.

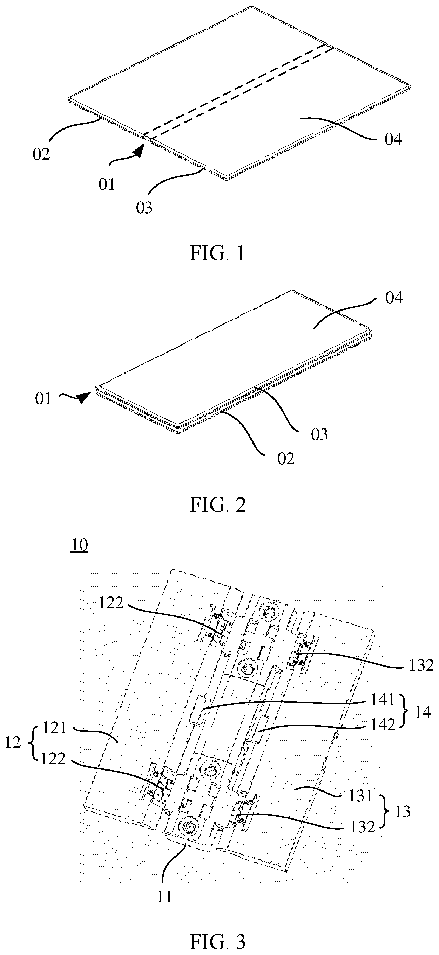

As shown in FIG. 1, a mobile phone is used as an example. The mobile phone may include a first housing 02 and a second housing 03 that are connected through a hinge 01. Under an action of the hinge 01, the first housing 02 and the second housing 03 may rotate relative to each other, to implement a folding function of the mobile phone. A flexible display 04 (for example, an OLED screen) may be disposed on surfaces of the first housing 02 and the second housing 03. As shown in FIG. 1, when the mobile phone is unfolded, the flexible display 04 may provide a large display area and operation area, to improve use performance. As shown in FIG. 2, after the mobile phone is folded, the flexible display 04 may be located on an outer side of the mobile phone, so that an area of the mobile phone can be reduced, and portable performance of the mobile phone is improved.

Currently, in the hinge 01, a contact area between a kinematic pair is small, which is not conducive to ensuring stability during motion. The kinematic pair refers to two components that are in direct contact, and the two components can move relative to each other. In the hinge 01, to enable the hinge 01 to have a large folding or unfolding angle, a plurality of kinematic pairs are usually included. The hinge 01 has a large quantity of components, which increases manufacturing difficulty and assembly difficulty, significantly increases manufacturing costs of the foldable device, and is not conducive to ensuring reliability of the hinge. In a process in which the hinge 01 is folded or unfolded, a contact area between a kinematic pair is small, which is not conducive to ensuring stability during motion.

Therefore, embodiments of this application provide a hinge that has a simple structure and good motion stability.

To make objectives, technical solutions, and advantages of this application clearer, the following further describes this application in detail with reference to accompanying drawings and specific embodiments.

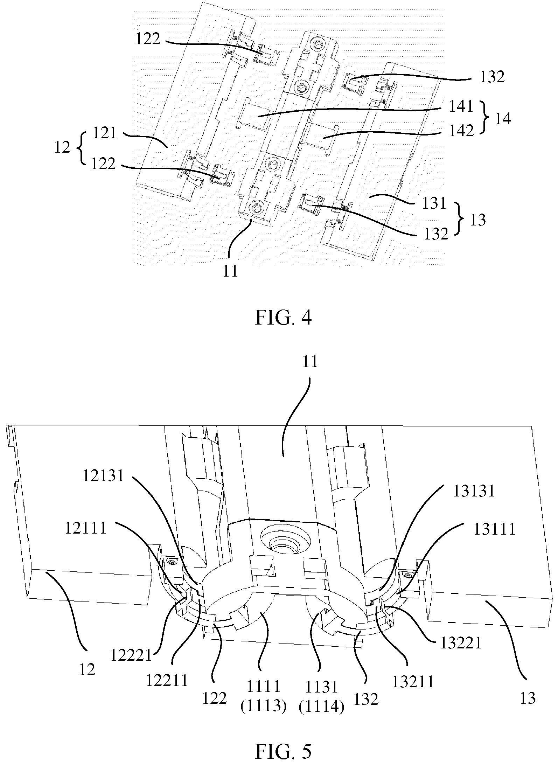

As shown in FIG. 3, FIG. 4, and FIG. 5, in an example provided in this application, a hinge 10 may include a main shaft 11, a first folding component 12, and a second folding component 13. The first folding component 12 and the second folding component 13 are disposed on two sides of the main shaft 11. The first folding component 12 and the second folding component 13 can rotate relative to the main shaft 11, to implement a folding function of the hinge 10. The first folding component 12 may include a first rotating part 121 and a first embedded shaft 122. The first rotating part 121 may be connected to the main shaft 11 through the first embedded shaft 122. Specifically, as shown in FIG. 5, the main shaft 11 has a first arc-shaped surface 1111, the first embedded shaft 122 has a second arc-shaped surface 12211, and the first arc-shaped surface 1111 contacts the second arc-shaped surface 12211, so that the first embedded shaft 122 is rotatably connected to the main shaft 11. The first rotating part 121 has a third arc-shaped surface 12111, the first embedded shaft 122 has a fourth arc-shaped surface 12221, and the third arc-shaped surface 12111 contacts the fourth arc-shaped surface 12221, so that the first rotating part 121 is rotatably connected to the first embedded shaft 122. An axis center of the first arc-shaped surface 1111, an axis center of the second arc-shaped surface 12211, an axis center of the third arc-shaped surface 12111, and an axis center of the fourth arc-shaped surface 12221 all coincide with each other, so that a rotation axis center of the first rotating part 121 coincides with a rotation axis center of the first embedded shaft 122. The second folding component 13 includes a second rotating part 131 and a second embedded shaft 132. The second rotating part 131 may be connected to the main shaft 11 through the second embedded shaft 132. Specifically, the main shaft 11 has a fifth arc-shaped surface 1131, the second embedded shaft 132 has a sixth arc-shaped surface 13211, and the fifth arc-shaped surface 1131 contacts the sixth arc-shaped surface 13211, so that the second embedded shaft 132 is rotatably connected to the main shaft 11. The second rotating part 131 has a seventh arc-shaped surface 13111, the second embedded shaft 132 has an eighth arc-shaped surface 13221, and the seventh arc-shaped surface 13111 contacts the eighth arc-shaped surface 13221, so that the second rotating part 131 is rotatably connected to the second embedded shaft 132. An axis center of the fifth arc-shaped surface 1131, an axis center of the sixth arc-shaped surface 13211, an axis center of the seventh arc-shaped surface 13111, and an axis center of the eighth arc-shaped surface 13221 all coincide with each other, so that a rotation axis center of the second rotating part 131 coincides with a rotation axis center of the second embedded shaft 132.

In an example provided in this application, the first rotating part 121 may be rotatably connected to the main shaft 11 through the first embedded shaft 122. The first rotating part 121 and the first embedded shaft 122 may form a kinematic pair, and the third arc-shaped surface 12111 contacts the fourth arc-shaped surface 12221, so that there is a large contact area between the first rotating part 121 and the first embedded shaft 122. Therefore, stability of the first rotating part 121 and the first embedded shaft 122 during relative motion can be improved. The first embedded shaft 122 and the main shaft 11 may form a kinematic pair, and the first arc-shaped surface 1111 contacts the second arc-shaped surface 12211, so that there is a large contact area between the first embedded shaft 122 and the main shaft 11. Therefore, stability of the first embedded shaft 122 and the main shaft 11 during relative motion can be improved. Correspondingly, the second rotating part 131 may be rotatably connected to the main shaft 11 through the second embedded shaft 132. The second rotating part 131 and the second embedded shaft 132 may form a kinematic pair, and the seventh arc-shaped surface 13111 contacts the eighth arc-shaped surface 13221, so that there is a large contact area between the second rotating part 131 and the second embedded shaft 132. Therefore, stability of the second rotating part 131 and the second embedded shaft 132 during relative motion can be improved. The second embedded shaft 132 and the main shaft 11 may form a kinematic pair, and the fifth arc-shaped surface 1131 contacts the sixth arc-shaped surface 13211, so that there is a large contact area between the second embedded shaft 132 and the main shaft 11. Therefore, stability of the second embedded shaft 132 and the main shaft 11 during relative motion can be improved.

In general, in an example provided in this application, the hinge 10 may be assembled by using the first rotating part 121, the second rotating part 131, the main shaft 11, the first embedded shaft 122, and the second embedded shaft 132, so that the hinge 10 has a good folding function, and has advantages of few components and a simple structure. In addition, the first embedded shaft 122 is rotatably connected to the main shaft 11 and the first rotating part 121 through an arc-shaped surface, and the second embedded shaft 132 is rotatably connected to the main shaft 11 and the second rotating part 131 through an arc-shaped surface, so that stability and reliability of the hinge 10 during motion can be effectively improved.

It should be noted that, as shown in FIG. 3 and FIG. 4, in an example provided in this application, the hinge 10 includes two first embedded shafts 122 and two second embedded shafts 132. In addition, the two first embedded shafts 122 are disposed at intervals in an axial direction of the main shaft 11, and the two second embedded shafts 132 are disposed at intervals in an axial direction of the main shaft 11. In other words, the first rotating part 121 may be connected to the main shaft 11 through the two first embedded shafts 122, and the second rotating part 131 may be connected to the main shaft 11 through the two second embedded shafts 132. In another example, one first embedded shaft 122, three first embedded shafts 122, or more first embedded shafts 122 may be disposed, and one second embedded shaft 132, three second embedded shafts 132, or more second embedded shafts 132 may be disposed. In an actual application, a quantity and locations of the first embedded shafts 122 and a quantity and locations of the second embedded shafts 132 may be properly set according to an actual requirement, and details are not described herein.

In addition, during specific disposition, a specific structure for implementing a rotating connection between the first embedded shaft 122 and the main shaft 11 and between the first embedded shaft 122 and the first rotating part 121 may be diversified.

For example, as shown in FIG. 5, FIG. 6, and FIG. 7, in an example provided in this application, the main shaft 11 has a first arc-shaped slot 111, the first embedded shaft 122 has a first arc-shaped arm 1221, and the first arc-shaped arm 1221 is slidably disposed in the first arc-shaped slot 111. The first arc-shaped surface 1111 is located on an inner wall of the first arc-shaped slot 111, the second arc-shaped surface 12211 is located on an outer surface of the first arc-shaped arm 1221, and the first arc-shaped surface 1111 contacts the second arc-shaped surface 12211, so that the first embedded shaft 122 is rotatably connected to the main shaft 11. In addition, the first rotating part 121 has a second arc-shaped arm 1211, the first embedded shaft 122 further has a second arc-shaped slot 1222, and the second arc-shaped arm 1211 is slidably disposed in the second arc-shaped slot 1222. The third arc-shaped surface 12111 is located on an outer surface of the second arc-shaped arm 1211, the fourth arc-shaped surface 12221 is located on an inner wall of the second arc-shaped slot 1222, and the third arc-shaped surface 12111 contacts the fourth arc-shaped surface 12221, so that the first embedded shaft 122 is rotatably connected to the first rotating part 121. An axis center of the first arc-shaped arm 1221, an axis center of the first arc-shaped slot 111, an axis center of the second arc-shaped arm 1211, and an axis center of the second arc-shaped slot 1222 all coincide with each other. In other words, the axis center of the first arc-shaped surface 1111, the axis center of the second arc-shaped surface 12211, the axis center of the third arc-shaped surface 12111, and the axis center of the fourth arc-shaped surface 12221 all coincide with each other.

In an example provided in this application, the first embedded shaft 122 is rotatably connected to the first rotating part 121 through contact between arc-shaped surfaces, so that there is a large contact area between the first embedded shaft 122 and the first rotating part 121, and motion stability and force strength between the first embedded shaft 122 and the first rotating part 121 can be improved. Correspondingly, the first embedded shaft 122 is rotatably connected to the main shaft 11 through contact between arc-shaped surfaces, so that there is a large contact area between the first embedded shaft 122 and the main shaft 11, and motion stability and force strength between the first embedded shaft 122 and the main shaft 11 can be improved.

In another example, an arc-shaped slot similar to the first arc-shaped slot 111 may alternatively be disposed on the first embedded shaft 122, and an arc-shaped arm similar to the first arc-shaped arm 1221 may alternatively be disposed on the main shaft 11. In other words, locations of the first arc-shaped slot 111 and the first arc-shaped arm 1221 may be replaced with each other. In addition, an arc-shaped slot similar to the second arc-shaped slot 1222 may alternatively be disposed on the first rotating part 121, and an arc-shaped arm similar to the second arc-shaped arm 1211 may be disposed on the first embedded shaft 122. In other words, locations of the second arc-shaped slot 1222 and the second arc-shaped arm 1211 may be replaced with each other.

In addition, in the foregoing example, the first rotating part 121 may be rotatably connected to the main shaft 11 through the first embedded shaft 122. However, in another example, the first rotating part 121 may alternatively be directly rotatably connected to the main shaft 11.

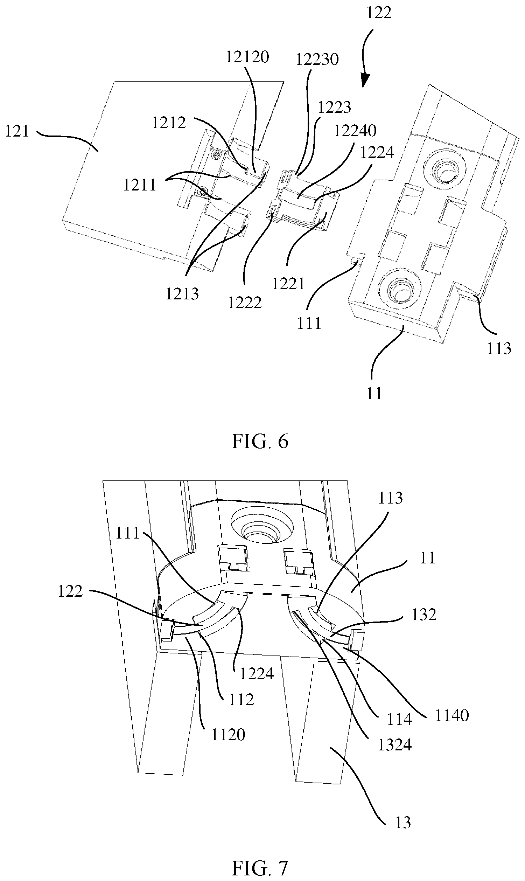

For example, as shown in FIG. 5 and FIG. 6, in an example provided in this application, the first rotating part 121 further has a fifth arc-shaped arm 1213, and the fifth arc-shaped arm 1213 is slidably disposed in the first arc-shaped slot 111. An outer surface of the fifth arc-shaped arm 1213 has a first auxiliary arc-shaped surface 12131, an inner wall of the first arc-shaped slot 111 has a second auxiliary arc-shaped surface 1113, and the first auxiliary arc-shaped surface 12131 contacts the second auxiliary arc-shaped surface 1113, so that the first rotating part 121 is rotatably connected to the main shaft 11. In addition, an axis center of the first auxiliary arc-shaped surface 12131, an axis center of the second auxiliary arc-shaped surface 113, and the axis center of the first arc-shaped surface 1111 all coincide with each other, so that smooth rotation between the first rotating part 121 and the main shaft 11 is ensured.

In an example provided in this application, the first rotating part 121 is rotatably connected to the main shaft 11 through contact between arc-shaped surfaces, so that there is a large contact area between the first rotating part 121 and the main shaft 11, and motion stability and force strength between the first rotating part 121 and the main shaft 11 can be improved.

In general, in an example provided in this application, the first rotating part 121 may be rotatably connected to the main shaft 11 through the first embedded shaft 122, so that stability when the first rotating part 121 and the main shaft 11 rotate relative to each other can be effectively ensured. In addition, the first rotating part 121 may further be directly rotatably connected to the main shaft 11, so that stability when the first rotating part 121 and the main shaft 11 rotate relative to each other can be further improved. As shown in FIG. 5 and FIG. 6, in an example provided in this application, in a direction perpendicular to a tangent of the second arc-shaped surface 12211, a cross section of the first embedded shaft 122 is of an I shape. The first embedded shaft 122 has two second arc-shaped surfaces 12211, and the two second arc-shaped surfaces 12211 are respectively located on two opposite surfaces of the first embedded shaft 122. The first embedded shaft 122 has two second arc-shaped slots 1222, and the two second arc-shaped slots 1222 are respectively located on two opposite sides of the first embedded shaft 122.

In addition, the first rotating part 121 has two second arc-shaped arms 1211, the two second arc-shaped arms 1211 are disposed opposite to each other, and the first embedded shaft 122 is clamped between the two second arc-shaped arms 1211, so that a reliable connection between the first rotating part 121 and the first embedded shaft 122 can be implemented, and location offset of the first rotating part 121 and the first embedded shaft 122 in an axial direction can be prevented.

In addition, the first rotating part 121 further has two fifth arc-shaped arms 1213, and the two fifth arc-shaped arms 1213 are disposed opposite to each other. The two second arc-shaped arms 1211 are located between the two fifth arc-shaped arms 1213, so that structural compactness of the second rotating part 121 can be improved.

In addition, as shown in FIG. 5, FIG. 6, and FIG. 7, in an example provided in this application, the first rotating part 121 has a first pressing surface 1212, and the first embedded shaft 122 has a second pressing surface 1223. When the first pressing surface 1212 presses against the second pressing surface 1223, the first rotating part 121 is used to drive the first embedded shaft 122 to slide in a direction of detaching from the first arc-shaped slot 111 (for example, rotate in a clockwise direction). Specifically, the fifth arc-shaped arm 1213 has a first protruding part 12120 that extends in an axial direction of the fifth arc-shaped arm 1213, and the first embedded shaft 122 has a second protruding part 12230 that extends in an axial direction of the first embedded shaft 122. After the first rotating part 121 and the first embedded shaft 122 are assembled, the first pressing surface 1212 is located on a side surface that is of the first protruding part 12120 and that faces the second protruding part 12230, and the second pressing surface 1223 is located on a side surface that is of the second protruding part 12230 and that faces the first protruding part 12120.

In addition, the main shaft 11 has a first limiting surface 112, the first embedded shaft 122 has a second limiting surface 1224, and when the first limiting surface 112 presses against the second limiting surface 1224, the first embedded shaft 122 is prevented from sliding in the direction of detaching from the first arc-shaped slot 111 (for example, rotate in the clockwise direction), and the first embedded shaft 122 is prevented from detaching from the main shaft 11. The second arc-shaped surface 12211 of the first embedded shaft 122 has a first concave part 12240. After the first embedded shaft 122 and the main shaft 11 are assembled, the second limiting surface 1224 is located on an inner wall that is of the first concave part 12240 and that faces an opening of the first arc-shaped slot 111. The first arc-shaped surface 1111 has a first protrusion 1120 that extends into the first concave part 12240, and the first limiting surface 112 is located on a side wall that is of the first protrusion 1120 and that faces the second limiting surface 1224.

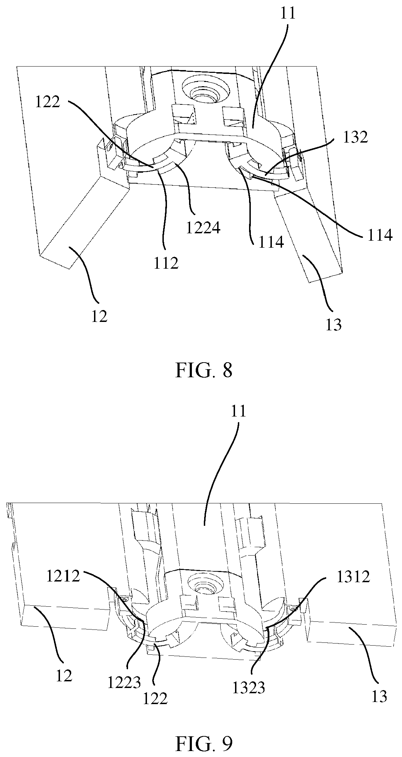

Refer to FIG. 5 to FIG. 9. As shown in FIG. 7, the hinge 10 is in a fully folded state, and the first embedded shaft 122 is located in the first arc-shaped slot 111. As shown in FIG. 8, after the first rotating part 121 rotates by a specific angle (for example, about 45°) in the clockwise direction under an action of an external force, the hinge 10 is gradually unfolded. In this case, the first pressing surface 1212 presses against the second pressing surface 1223 (not shown in the figure). As shown in FIG. 9, in a process in which the first rotating part 121 continues to rotate in the clockwise direction under the action of the external force, the first rotating part 121 may apply an acting force to the second pressing surface 1223 of the first embedded shaft 122 through the first pressing surface 1212, so that the first embedded shaft 122 rotates in the clockwise direction with the first rotating part 121, and the first embedded shaft 122 slides in a direction of detaching from the first arc-shaped slot 111. In addition, after the first rotating part 121 rotates by a specific angle (for example, about 90°), the hinge 10 is in an unfolded state. In this case, the first limiting surface 112 presses against the second limiting surface 1224, and the main shaft 11 can prevent the first embedded shaft 122 from continuing to rotate in the clockwise direction, so that the first embedded shaft 122 can be prevented from detaching from the first arc-shaped slot 111. In addition, because the first pressing surface 1212 presses against the second pressing surface 1223 in this case, after the first limiting surface 112 presses against the second limiting surface 1224, the first rotating part 121 can be further prevented from continuing to rotate in the clockwise direction, so that the hinge 10 can be prevented from being excessively unfolded.

It should be noted that, in the foregoing example, when the first rotating part 121 rotates about 45° in the clockwise direction, the first pressing surface 1212 presses against the second pressing surface 1223. In an actual application, the first pressing surface 1212 may press against the second pressing surface 1223 when the first rotating part 121 rotates by an angle such as 30°, 40°, or 60° in the clockwise direction. This is not limited in this application. In addition, when the first rotating part 121 rotates about 90° in the clockwise direction, the first limiting surface 112 presses against the second limiting surface 1224. In other words, a range in which the first rotating part 121 can rotate is about 90°. In an actual application, a maximum rotation angle of the first rotating part 121 may alternatively be 80°, 95°, 100°, or the like. This is not limited in this application.

It may be understood that, in the hinge 10 provided in embodiments of this application, the first folding component 12 and the second folding component 13 are respectively disposed on the two sides of the main shaft 11, and structure types of the first folding component 12 and the second folding component 13 may be approximately the same. Therefore, when the second folding component 13 is specifically disposed, corresponding disposition may be performed with reference to a specific structure of the first folding component 12. In addition, a connection structure between the main shaft 11 and the second folding component 13 may also be correspondingly disposed with reference to a connection structure between the main shaft 11 and the first folding component 12. This is not described in detail herein.

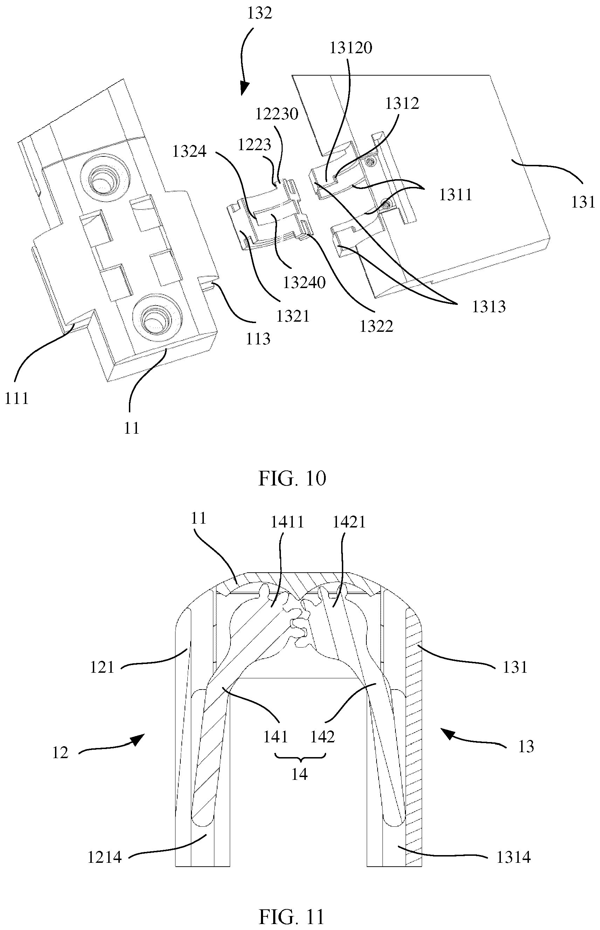

Simply speaking, as shown in FIG. 5 and FIG. 10, the main shaft 11 further has a third arc-shaped slot 113, the second embedded shaft 132 has a third arc-shaped arm 1321, and the third arc-shaped arm 1321 is slidably disposed in the third arc-shaped slot 113. The fifth arc-shaped surface 1131 is located on an inner wall of the third arc-shaped slot 113, the sixth arc-shaped surface 13211 is located on an outer surface of the third arc-shaped arm 1321, and the fifth arc-shaped surface 1131 contacts the sixth arc-shaped surface 13211, so that the second embedded shaft 132 is rotatably connected to the main shaft 11. In addition, the second rotating part 131 has a fourth arc-shaped arm 1311, the second embedded shaft 132 further has a fourth arc-shaped slot 1322, and the fourth arc-shaped arm 1311 is slidably disposed in the fourth arc-shaped slot 1322. The seventh arc-shaped surface 13111 is located on an outer surface of the fourth arc-shaped arm 1311, the eighth arc-shaped surface 13221 is located on an inner wall of the fourth arc-shaped slot 1322, and the seventh arc-shaped surface 13111 contacts the eighth arc-shaped surface 13221, so that the second embedded shaft 132 is rotatably connected to the second rotating part 131. An axis center of the third arc-shaped arm 1321, an axis center of the third arc-shaped slot 113, an axis center of the fourth arc-shaped arm 1311, and an axis center of the fourth arc-shaped slot 1322 all coincide with each other. In other words, the axis center of the fifth arc-shaped surface 1131, the axis center of the sixth arc-shaped surface 13211, the axis center of the seventh arc-shaped surface 13111, and the axis center of the eighth arc-shaped surface 13221 all coincide with each other, so that the rotation axis center of the second rotating part 131 coincides with the rotation axis center of the second embedded shaft 132.

In addition, the second rotating part 131 further has a third pressing surface 1312, and the second embedded shaft 132 has a fourth pressing surface 1323. When the third pressing surface 1312 presses against the fourth pressing surface 1323, the second rotating part 131 is used to drive the second embedded shaft 132 to slide in a direction of detaching from the third arc-shaped slot 113. The sixth arc-shaped arm 1313 has a third protruding part 13120 that extends in an axial direction of the sixth arc-shaped arm 1313, and the second embedded shaft 132 has a fourth protruding part 13230 that extends in an axial direction of the second embedded shaft 132. After the second rotating part 131 and the second embedded shaft 132 are assembled, the third pressing surface 1312 is located on a side surface that is of the third protruding part 13120 and that faces the fourth protruding part 13230, and the fourth pressing surface 1323 is located on a side surface that is of the fourth protruding part 13230 and that faces the third protruding part 13120.

In addition, the main shaft 11 has a third limiting surface 114, the second embedded shaft 132 has a fourth limiting surface 1324, and when the third limiting surface 114 presses against the fourth limiting surface 1324, the second embedded shaft 132 is prevented from sliding in the direction of detaching from the third arc-shaped slot 113, so that the second embedded shaft 132 can be prevented from detaching from the main shaft 11. The sixth arc-shaped surface 13211 of the second embedded shaft 132 has a second concave part 13240. After the main shaft 11 and the second embedded shaft 132 are assembled, the fourth limiting surface 1324 is located on an inner wall that is of the second concave part 13240 and that faces an opening of the third arc-shaped slot 113. The fifth arc-shaped surface 1131 has a second protrusion 1140 that extends into the second concave part 13240, and the third limiting surface 114 is located on a side wall that is of the second protrusion 1140 and that faces the fourth limiting surface 1324.

In addition, the second rotating part 131 has the sixth arc-shaped arm 1313, and the sixth arc-shaped arm 1313 is slidably disposed in the third arc-shaped slot 113, so that the second rotating part 131 is rotatably connected to the main shaft 11. An outer surface of the sixth arc-shaped arm 1313 has a third auxiliary arc-shaped surface 13131, an inner wall of the third arc-shaped slot 113 has a fourth auxiliary arc-shaped surface 1114, and the third auxiliary arc-shaped surface 13131 contacts the fourth auxiliary arc-shaped surface 1114, so that the second rotating part 131 is rotatably connected to the main shaft 11.

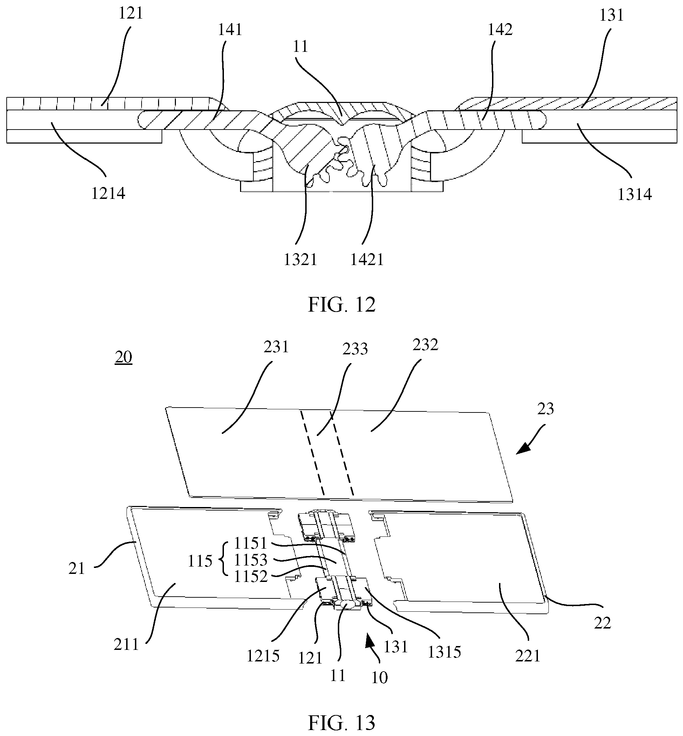

In addition, as shown in FIG. 11 and FIG. 12, in an example provided in this application, the hinge 10 may further include a synchronization component 14. The first folding component 12 and the second folding component 13 may rotate synchronously through the synchronization component 14. Specifically, the synchronization component 14 may include a first synchronization part 141 and a second synchronization part 142. One end of the first synchronization part 141 is slidably connected to the first rotating part 121, the other end of the first synchronization part 141 is rotatably connected to the main shaft 11, and a rotation axis center of the first synchronization part 141 is parallel to a rotation axis center of the first rotating part 121. One end of the second synchronization part 142 is slidably connected to the second rotating part 131, the other end of the second synchronization part 142 is rotatably connected to the main shaft 11, and a rotation axis center of the second synchronization part 142 is parallel to a rotation axis center of the second rotating part 131. In addition, the first synchronization part 141 has a first gear part 1411, the second synchronization part 142 has a second gear part 1421, and the first gear part 1411 meshes with the second gear part 1421.

Specifically, the first rotating part 121 has a first sliding slot 1214, and one end of the first synchronization part 141 is located in the first sliding slot 1214 and is slidably attached to an inner wall of the first sliding slot 1214, so that the first rotating part 121 is slidably connected to the first synchronization part 141, and the first synchronization part 141 can rotate with the first rotating part 121. The second rotating part 131 has a second sliding slot 1314, and one end of the second synchronization part 142 is located in the second sliding slot 1314 and is slidably attached to an inner wall of the second sliding slot 1314, so that the second synchronization part 142 can rotate with the second rotating part 131.

During actual use, when an external force (for example, a hand) is applied to the first rotating part 121 and the second rotating part 131 to fold or unfold the hinge 10, the first rotating part 121 may drive the first synchronization part 141 to rotate together with the first rotating part 121, and the second rotating part 131 may drive the second synchronization part 142 to rotate together with the second rotating part 131. In addition, because the first gear part 1411 of the first synchronization part 141 meshes with the second gear part 1421 of the second synchronization part 142, the first synchronization part 141 and the second synchronization part 142 can rotate toward or against each other at a same rotation speed. Correspondingly, the first rotating part 121 and the second rotating part can rotate toward or against each other at a same rotation speed, so that the first folding component 12 and the second folding component 13 can rotate synchronously.

It may be understood that, in an actual application, the first gear part 1411 may alternatively mesh with the second gear part 1421 by using two or more gears, so that the first gear part 1141 is in transmission connection to the second gear part 1421. Alternatively, in another example, the synchronization component 14 may alternatively be a currently common type, and details are not described herein.

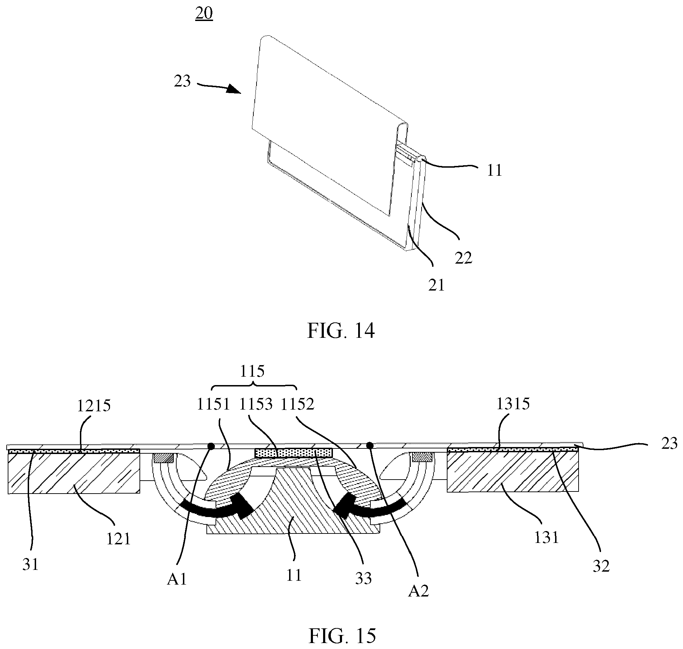

In addition, FIG. 13 and FIG. 14 are diagrams of an exploded structure of a foldable device 20 according to an embodiment of this application.

The foldable device 20 may include a first housing 21, a second housing 22, and a flexible display 23, and further includes the hinge 10 described above. The first housing 21 is fastened to a first rotating part 121, and the second housing 22 is fastened to a second rotating part 131. A first part 231 of the flexible display 23 is fastened to the first housing 21, and a second part 232 of the flexible display 23 is fastened to the second housing 22.

In an example provided in this application, the first housing 21 has a first mounting surface 211 for mounting the flexible display 23, and the second housing 12 has a second mounting surface 221 for mounting the flexible display 23.

In addition, as shown in FIG. 13, a main shaft 11 has a support surface 115 for supporting the flexible display 23. The support surface 115 is approximately U-shaped. The support surface 115 has an arc-shaped surface 1151, an arc-shaped surface 1152, and a plane 1153 located between the arc-shaped surface 1151 and the arc-shaped surface 1152.

In addition, the first rotating part 121 has a first support surface 1215 for supporting the flexible display, and the second rotating part 131 has a second support surface 1315 for supporting the flexible display 23. When the hinge 10 is in an unfolded state, both the first support surface 1215 and the second support surface 1315 are located in a reference plane.

In an actual application, a back surface (that is, a surface away from a display surface) of the flexible display 23 may be fastened to the first rotating part 121, the second rotating part 131, and the main shaft 11.

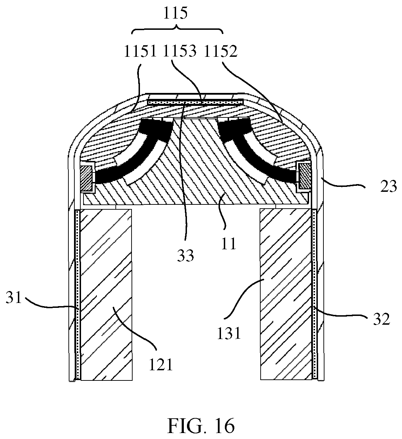

As shown in FIG. 15 and FIG. 16, specifically, the back surface of the flexible display 23 may be bonded and fastened to the first support surface 1215 by using a back adhesive 31, and may be bonded and fastened to the second support surface 1315 by using a back adhesive 32. When the foldable device is folded or unfolded, the first rotating part 121 and the second rotating part 131 can drive the flexible display 23 to fold or unfold. When the foldable device is in a folded posture, the flexible display 23 wraps outer sides of the first rotating part 121, the main shaft 11, and the second rotating part 131, and the first support surface 1215, the second support surface 1315, and the support surface 115 can effectively support the flexible display 23. The support surface 115 is arc-shaped. Therefore, after the flexible display 23 is folded, the arc-shaped surface 1151, the arc-shaped surface 1152, and the plane 1153 can still effectively support the flexible display 23. When an area that is of the flexible display 23 and that corresponds to the support surface 115 is squeezed or collided from outside, the support surface 115 can effectively prevent a bad case such as a dent, a crease, or a break from occurring on the flexible display 23, so that security of the flexible display 23 can be effectively improved. In addition, when the foldable device is in the unfolded state, the plane can effectively support the flexible display 23. When the flexible display 23 is touched or pressed by a human hand, the plane, the first support surface 1215, and the second support surface 1315 may provide effective support for the flexible display 23, so that a bad case such as deformation or a crack on the flexible display 23 is prevented after the flexible display 23 is pressed. Certainly, in some cases, after the flexible display 23 is pressed and the back surface of the flexible display 23 is in contact with the arc-shaped surface 1151 and the arc-shaped surface 1152, the arc-shaped surface 1151 and the arc-shaped surface 1152 can also effectively support the flexible display 23, so that large bending deformation of the flexible display 23 can be prevented, and use safety of the flexible display 23 can be ensured.

In general, in an example provided in this application, after the support surface 115 is set to be U-shaped, in a process in which the flexible display 23 is unfolded or folded, the support surface 115 can effectively support the flexible display 23. In addition, in a folding process of the flexible display 23, the U-shaped support surface 115 does not affect normal bending of the flexible display 23, so that use safety of the flexible display 23 is ensured.

It may be understood that, in an example provided in this application, the back surface of the flexible display 23 may alternatively be bonded and fastened to the plane 1153 by using a back adhesive 33, so that a bad case such as a protrusion of the flexible display 23 can be effectively prevented.

In addition, during specific disposition, a thickness of the back adhesive 33 may be slightly greater than or equal to a thickness of the back adhesive 31 and a thickness of the back adhesive 32. Alternatively, it may be understood that when the hinge 10 is in an unfolded state, the support surface 115 is not higher than a plane on which the first support surface 1215 and the second support surface 1315 are located. To be specific, a distance between the support surface 115 and the back surface of the flexible display 23 may be greater than distances between the first support surface 1215 and the second support surface 1315, and the back surface of the flexible display 23. Therefore, there is sufficient moving space between the support surface 115 and the flexible display 23. When a bending area 233 of the flexible display 23 is bent, the support surface 115 does not generate large extrusion pressure on the bending area 233.

In addition, during specific disposition, distances between a rotation axis center A1 of the first rotating part 121 and a first embedded shaft 122 and a rotation axis center A2 of the second rotating part 131 and a second embedded shaft 132, and the neutral layer of the flexible display 23 may be less than or equal to 1 mm. When the distances between the rotation axis centers of the first rotating part 121, the second rotating part 131, the first embedded shaft 122, and the second embedded shaft 132, and the neutral layer of the flexible display 23 are small, constant management of the flexible display 23 is facilitated. In a process in which the foldable device 20 is folded or unfolded, the flexible display 23 is not easily subject to tensile stress or extrusion stress, so that security of the flexible display 23 is improved.

The neutral layer refers to a transition layer that is neither subject to a tensile stress nor subject to a compressive stress and that is located between an outer layer and an inner layer. When the flexible display 23 is in a bending process, the outer layer (for example, a layer close to the display surface) is subject to a tensile stress, and the inner layer (for example, a layer close to a back surface) is subject to a compressive stress. The transition layer may be referred to as the neutral layer of the flexible display 23.

It may be understood that, in an actual application, the hinge 10 may be further used in another electronic device having a folding requirement. A specific application scenario of the hinge 10 and a type of a foldable device are not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

"A plurality of" in this application refers to two or more than two. "And/or" describes an association relationship between associated objects, and indicates that three relationships may exist. For example, A and/or B may indicate the following three cases: A exists alone, both A and B exist, and B exists alone, where A and B may be singular or plural.

It may be understood that various numbers in embodiments of this application are merely used for differentiation for ease of description, and are not used to limit the scope of embodiments of this application. The sequence numbers of the foregoing processes do not mean execution sequences, and the execution sequences of the processes should be determined based on functions and internal logic of the processes.

## Claims

1. A hinge (10) for a foldable device, comprising a main shaft (11), a first folding component (12), and a second folding component (13), wherein the first folding component (12) and the second folding component (13) are disposed on two sides of the main shaft (11);
the first folding component (12) comprises a first rotating part (121) and a first embedded shaft (122);
the main shaft (11) has a first arc-shaped surface (1111), the first embedded shaft (122) has a second arc-shaped surface (12211), and the first arc-shaped surface (1111) contacts the second arc-shaped surface (12211);
the first rotating part (121) has a third arc-shaped surface (12111), the first embedded shaft (122) has a fourth arc-shaped surface (12221), and the third arc-shaped surface (12111) contacts the fourth arc-shaped surface (12221);
an axis center of the first arc-shaped surface (1111), an axis center of the second arc-shaped surface (12211), an axis center of the third arc-shaped surface (12111), and an axis center of the fourth arc-shaped surface (12221) all coincide with each other;
the second folding component (13) comprises a second rotating part (131) and a second embedded shaft (132);
the main shaft (11) has a fifth arc-shaped surface (1131), the second embedded shaft (132) has a sixth arc-shaped surface (13211), and the fifth arc-shaped surface (1131) contacts the sixth arc-shaped surface (13211);
the second rotating part (131) has a seventh arc-shaped surface (13111), the second embedded shaft (132) has an eighth arc-shaped surface (13221), and the seventh arc-shaped surface (13111) contacts to the eighth arc-shaped surface (13221); and
an axis center of the fifth arc-shaped surface (1131), an axis center of the sixth arc-shaped surface (13211), an axis center of the seventh arc-shaped surface (13111), and an axis center of the eighth arc-shaped surface (13221) all coincide with each other.

2. The hinge (10) according to claim 1, wherein the first rotating part (121) has a first auxiliary arc-shaped surface (12131), the main shaft (11) has a second auxiliary arc-shaped surface (1113), the first auxiliary arc-shaped surface (12131) contacts the second auxiliary arc-shaped surface (1113), and an axis center of the first auxiliary arc-shaped surface (12131), the axis center of the first arc-shaped surface (1111), and an axis center of the second auxiliary arc-shaped surface (1113) all coincide with each other; and
the second rotating part (131) has a third auxiliary arc-shaped surface (13131), the main shaft (11) has a fourth auxiliary arc-shaped surface (1114), the third auxiliary arc-shaped surface (13131) contacts the fourth auxiliary arc-shaped surface (1114), and an axis center of the third auxiliary arc-shaped surface (13131), the axis center of the third arc-shaped surface (12111), and an axis center of the fourth auxiliary arc-shaped surface (1114) all coincide with each other.

3. The hinge (10) according to claim 1 or 2, wherein the main shaft (11) has a first arc-shaped slot (111), the first embedded shaft (122) has a first arc-shaped arm (1221), and the first arc-shaped arm (1221) is slidably disposed in the first arc-shaped slot (111), wherein the first arc-shaped surface (1111) is located on an inner wall of the first arc-shaped slot (111), and the second arc-shaped surface (12211) is located on an outer surface of the first arc-shaped arm (1221);
the first rotating part (121) has a second arc-shaped arm (1211), the first embedded shaft (122) further has a second arc-shaped slot (1222), and the second arc-shaped arm (1211) is slidably disposed in the second arc-shaped slot (1222), wherein the third arc-shaped surface (12111) is located on an outer surface of the second arc-shaped arm (1211), and the fourth arc-shaped surface (12221) is located on an inner wall of the second arc-shaped slot (1222);
the main shaft (11) further has a third arc-shaped slot (1113), the second embedded shaft (132) has a third arc-shaped arm (1321), and the third arc-shaped arm (1321) is slidably disposed in the third arc-shaped slot (1113), wherein the fifth arc-shaped surface (1131) is located on an inner wall of the third arc-shaped slot (1113), and the sixth arc-shaped surface (13211) is located on an outer surface of the third arc-shaped arm (1321); and
the second rotating part (131) has a fourth arc-shaped arm (1311), the second embedded shaft (132) further has a fourth arc-shaped slot (1322), and the fourth arc-shaped arm (1311) is slidably disposed in the fourth arc-shaped slot (1322), wherein the seventh arc-shaped surface (13111) is located on an outer surface of the fourth arc-shaped arm (1311), and the eighth arc-shaped surface (13221) is located on an inner wall of the fourth arc-shaped slot (1322).

4. The hinge (10) according to claim 3, wherein the first rotating part (121) further has a fifth arc-shaped arm (1213), and the fifth arc-shaped arm (1213) is slidably disposed in the first arc-shaped slot (111), wherein the first auxiliary arc-shaped surface (12131) is located on an outer surface of the fifth arc-shaped arm (1213), and the second auxiliary arc-shaped surface (1113) is located on the inner wall of the first arc-shaped slot (111); and
the second rotating part (131) further has a sixth arc-shaped arm (1313), and the sixth arc-shaped arm (1313) is slidably disposed in the third arc-shaped slot (1113), wherein the third auxiliary arc-shaped surface (13131) is located on an outer surface of the sixth arc-shaped arm (1313), and the fourth auxiliary arc-shaped surface (1114) is located on the inner wall of the third arc-shaped slot (1113).

5. The hinge (10) according to claim 3 or 4, wherein the first rotating part (121) has a first pressing surface (1212), and the first embedded shaft (122) has a second pressing surface (1223);
when the first pressing surface (1212) presses against the second pressing surface (1223), the first rotating part (121) is used to drive the first embedded shaft (122) to slide in a direction of detaching from the first arc-shaped slot (111);
the second rotating part (131) further has a third pressing surface (1312), and the second embedded shaft (132) has a fourth pressing surface (1323); and
when the third pressing surface (1312) presses against the fourth pressing surface (1323), the second rotating part (131) is used to drive the second embedded shaft (132) to slide in a direction of detaching from the third arc-shaped slot (1113).

6. The hinge (10) according to any one of claims 3 to 5, wherein in a direction perpendicular to a tangent of the second arc-shaped surface (12211), a cross section of the first embedded shaft (122) is of an I shape;
the first embedded shaft (122) has two second arc-shaped surfaces (12211), and the two second arc-shaped surfaces (12211) are respectively located on two opposite surfaces of the first embedded shaft (122);
the first embedded shaft (122) has two second arc-shaped slots (1222), and the two second arc-shaped slots (1222) are respectively located on two opposite sides of the first embedded shaft (122);
in a direction perpendicular to a tangent of the fourth arc-shaped surface (12221), a cross section of the second embedded shaft (132) is of an I shape;
the second embedded shaft (132) has two fourth arc-shaped surfaces (12221), and the two fourth arc-shaped surfaces (12221) are respectively located on two opposite surfaces of the second embedded shaft (132); and
the second embedded shaft (132) has two fourth arc-shaped slots (1322), and the two fourth arc-shaped slots (1322) are respectively located on two opposite sides of the second embedded shaft (132).

7. The hinge (10) according to claim 6, wherein the first rotating part (121) has two second arc-shaped arms (1211), the two second arc-shaped arms (1211) are disposed opposite to each other, and the first embedded shaft (122) is clamped between the two second arc-shaped arms (1211); and
the second rotating part (131) has two fourth arc-shaped arms (1311), the two fourth arc-shaped arms (1311) are disposed opposite to each other, and the second embedded shaft (132) is clamped between the two fourth arc-shaped arms (1311).

8. The hinge (10) according to claim 5, wherein the fifth arc-shaped arm (1213) has a first protruding part (12120) that extends in an axial direction of the fifth arc-shaped arm (1213), the first embedded shaft (122) has a second protruding part (12230) that extends in an axial direction of the first embedded shaft (122), the first pressing surface (1212) is located on a side surface that is of the first protruding part (12120) and that faces the second protruding part (12230), and the second pressing surface (1223) is located on a side surface that is of the second protruding part (12230) and that faces the first protruding part (12120); and
the sixth arc-shaped arm (1313) has a third protruding part (13120) that extends in an axial direction of the sixth arc-shaped arm (1313), the second embedded shaft (132) has a fourth protruding part (13230) that extends in an axial direction of the second embedded shaft (132), the third pressing surface (1312) is located on a side surface that is of the third protruding part (13120) and that faces the fourth protruding part (13230), and the fourth pressing surface (1323) is located on a side surface that is of the fourth protruding part (13230) and that faces the third protruding part (13120).

9. The hinge (10) according to any one of claims 3 to 8, wherein the main shaft (11) has a first limiting surface (112), the first embedded shaft (122) has a second limiting surface (1224), and when the first limiting surface (112) presses against the second limiting surface (1224), the first embedded shaft (122) is prevented from sliding in the direction of detaching from the first arc-shaped slot (111); and
the main shaft (11) has a third limiting surface (114), the second embedded shaft (132) has a fourth limiting surface (1324), and when the third limiting surface (114) presses against the fourth limiting surface (1324), the second embedded shaft (132) is prevented from sliding in the direction of detaching from the third arc-shaped slot (1113).

10. The hinge (10) according to claim 9, wherein the second arc-shaped surface (12211) of the first embedded shaft (122) has a first concave part (12240), the second limiting surface (1224) is located on an inner wall that is of the first concave part (12240) and that faces an opening of the first arc-shaped slot (111), the first arc-shaped surface (1111) has a first protrusion (1120) that extends into the first concave part (12240), and the first limiting surface (112) is located on a side wall that is of the first protrusion (1120) and that faces the second limiting surface (1224); and
the sixth arc-shaped surface (13211) of the second embedded shaft (132) has a second concave part (13240), the fourth limiting surface (1324) is located on an inner wall that is of the second concave part (13240) and that faces an opening of the third arc-shaped slot (1113), the fifth arc-shaped surface (1131) has a second protrusion (1140) that extends into the second concave part (13240), and the third limiting surface (114) is located on a side wall that is of the second protrusion (1140) and that faces the fourth limiting surface (1324).

11. The hinge (10) according to any one of claims 1 to 10, wherein the main shaft (11) has a support surface for supporting a flexible display, and the support surface is U-shaped or elliptical.

12. The hinge (10) according to claim 11, wherein concave surfaces of the first arc-shaped surface (1111), the second arc-shaped surface (12211), the third arc-shaped surface (12111), the fourth arc-shaped surface (12221), the fifth arc-shaped surface (1131), the sixth arc-shaped surface (13211), the seventh arc-shaped surface (13111), and the eighth arc-shaped surface (13221) are all disposed facing the flexible display; and
wherein the first rotating part (121) has a first support surface (1215) for supporting the flexible display, the second rotating part (131) has a second support surface (1315) for supporting the flexible display, and when the hinge (10) is in an unfolded state, both the first support surface (1215) and the second support surface (1315) are located in a same plane, and a distance between the support surface and a back surface of the flexible display is greater than distances between the first support surface (1215) and the second support surface (1315), and the back surface of the flexible display.

13. The hinge (10) according to any one of claims 1 to 12, wherein the hinge (10) further comprises a synchronization component (14), and the synchronization component (14) comprises a first synchronization part (141) and a second synchronization part (142);
one end of the first synchronization part (141) is slidably connected to the first rotating part (121), the other end of the first synchronization part (141) is rotatably connected to the main shaft (11), and a rotation axis center of the first synchronization part (141) is parallel to a rotation axis center of the first rotating part (121);
one end of the second synchronization part (142) is slidably connected to the second rotating part (131), the other end of the second synchronization part (142) is rotatably connected to the main shaft (11), and a rotation axis center of the second synchronization part (142) is parallel to a rotation axis center of the second rotating part (131); and
the first synchronization part (141) has a first gear part (1411), the second synchronization part (142) has a second gear part (1421), and the first gear part (1411) is in transmission connection to the second gear part (1421).

14. A foldable device, comprising a first housing, a second housing, and a flexible display, and further comprising the hinge (10) according to any one of claims 1 to 13, wherein
the first housing is fastened to the first rotating part (121), and the second housing is fastened to the second rotating part (131); and
a first part of the flexible display is connected to the first housing, and a second part of the flexible display is fastened to the second housing.

15. The foldable device according to claim 14, wherein a distance between a neutral layer of the flexible display and each of a rotation axis center of the first rotating part (121) and the first embedded shaft (122) and a rotation axis center of the second rotating part (131) and the second embedded shaft (132) is less than or equal to 1 mm.

## Patentansprüche

1. Scharnier (10) für eine klappbare Vorrichtung, wobei das Scharnier eine Hauptwelle (11), eine erste Klappkomponente (12) und eine zweite Klappkomponente (13) umfasst, wobei die erste Klappkomponente (12) und die zweite Klappkomponente (13) auf zwei Seiten der Hauptwelle (11) angeordnet sind; wobei
die erste Klappkomponente (12) ein erstes Drehteil (121) und eine erste eingebettete Welle (122) umfasst;
die Hauptwelle (11) eine erste bogenförmige Oberfläche (1111) aufweist, die erste eingebettete Welle (122) eine zweite bogenförmige Oberfläche (12211) aufweist und die erste bogenförmige Oberfläche (1111) die zweite bogenförmige Oberfläche (12211) berührt;
das erste Drehteil (121) eine dritte bogenförmige Oberfläche (12111) aufweist, die erste eingebettete Welle (122) eine vierte bogenförmige Oberfläche (12221) aufweist und die dritte bogenförmige Oberfläche (12111) die vierte bogenförmige Oberfläche (12221) berührt;
ein Achsmittelpunkt der ersten bogenförmigen Oberfläche (1111), ein Achsmittelpunkt der zweiten bogenförmigen Oberfläche (12211), ein Achsmittelpunkt der dritten bogenförmigen Oberfläche (12111) und ein Achsmittelpunkt der vierten bogenförmigen Oberfläche (12221) alle zusammenfallen;
die zweite Klappkomponente (13) ein zweites Drehteil (131) und eine zweite eingebettete Welle (132) umfasst;
die Hauptwelle (11) eine fünfte bogenförmige Oberfläche (1131) aufweist, die zweite eingebettete Welle (132) eine sechste bogenförmige Oberfläche (13211) aufweist und die fünfte bogenförmige Oberfläche (1131) die sechste bogenförmige Oberfläche (13211) berührt;
das zweite Drehteil (131) eine siebente bogenförmige Oberfläche (13111) aufweist, die zweite eingebettete Welle (132) eine achte bogenförmige Oberfläche (13221) aufweist und die siebente bogenförmige Oberfläche (13111) die achte bogenförmige Oberfläche (13221) berührt; und
ein Achsmittelpunkt der fünften bogenförmigen Oberfläche (1131), ein Achsmittelpunkt der sechsten bogenförmigen Oberfläche (13211), ein Achsmittelpunkt der siebenten bogenförmigen Oberfläche (13111) und ein Achsmittelpunkt der achten bogenförmigen Oberfläche (13221) alle zusammenfallen.

2. Scharnier (10) nach Anspruch 1, wobei das erste Drehteil (121) eine erste bogenförmige Zusatzoberfläche (12131) aufweist, die Hauptwelle (11) eine zweite bogenförmige Zusatzoberfläche (1113) aufweist, die erste bogenförmige Zusatzoberfläche (12131) die zweite bogenförmige Zusatzoberfläche (1113) berührt und ein Achsmittelpunkt der ersten bogenförmigen Zusatzoberfläche (12131), der Achsmittelpunkt der ersten bogenförmigen Oberfläche (1111) und ein Achsmittelpunkt der zweiten bogenförmigen Zusatzoberfläche (1113) alle zusammenfallen; und
das zweite Drehteil (131) eine dritte bogenförmige Zusatzoberfläche (13131) aufweist, die Hauptwelle (11) eine vierte bogenförmige Zusatzoberfläche (1114) aufweist, die dritte bogenförmige Zusatzoberfläche (13131) die vierte bogenförmige Zusatzoberfläche (1114) berührt und ein Achsmittelpunkt der dritten bogenförmigen Zusatzoberfläche (13131), der Achsmittelpunkt der dritten bogenförmigen Oberfläche (12111) und ein Achsmittelpunkt der vierten bogenförmigen Zusatzoberfläche (1114) alle zusammenfallen.

3. Scharnier (10) nach Anspruch 1 oder 2, wobei die Hauptwelle (11) einen ersten bogenförmigen Schlitz (111) aufweist, die erste eingebettete Welle (122) einen ersten bogenförmigen Arm (1221) aufweist und der erste bogenförmige Arm (1221) in dem ersten bogenförmigen Schlitz (111) gleitfähig angeordnet ist, wobei sich die erste bogenförmige Oberfläche (1111) an einer Innenwand des ersten bogenförmigen Schlitzes (111) befindet und sich die zweite bogenförmige Oberfläche (12211) an einer Außenoberfläche des ersten bogenförmigen Arms (1221) befindet;
das erste Drehteil (121) einen zweiten bogenförmigen Arm (1211) aufweist, die erste eingebettete Welle (122) ferner einen zweiten bogenförmigen Schlitz (1222) aufweist und der zweite bogenförmige Arm (1221) in dem zweiten bogenförmigen Schlitz (1222) gleitfähig angeordnet ist, wobei sich die dritte bogenförmige Oberfläche (12111) an einer Außenoberfläche des zweiten bogenförmigen Arms (1211) befindet und sich die vierte bogenförmige Oberfläche (12221) an einer Innenwand des zweiten bogenförmigen Schlitzes (1222) befindet;
die Hauptwelle (11) ferner einen dritten bogenförmigen Schlitz (1113) aufweist, die zweite eingebettete Welle (132) einen dritten bogenförmigen Arm (1321) aufweist und der dritte bogenförmige Arm (1321) in dem dritten bogenförmigen Schlitz (1113) gleitfähig angeordnet ist, wobei sich die fünfte bogenförmige Oberfläche (1131) an einer Innenwand des dritten bogenförmigen Schlitzes (1113) befindet und sich die sechste bogenförmige Oberfläche (13211) an einer Außenoberfläche des dritten bogenförmigen Arms (1321) befindet; und
das zweite Drehteil (131) einen vierten bogenförmigen Arm (1311) aufweist, die zweite eingebettete Welle (132) ferner einen vierten bogenförmigen Schlitz (1322) aufweist und der vierte bogenförmige Arm (1311) in dem vierten bogenförmigen Schlitz (1322) gleitfähig angeordnet ist, wobei sich die siebente bogenförmige Oberfläche (13111) an einer Außenoberfläche des vierten bogenförmigen Arms (1311) befindet und sich die achte bogenförmige Oberfläche (13221) an einer Innenwand des vierten bogenförmigen Schlitzes (1322) befindet.

4. Scharnier (10) nach Anspruch 3, wobei das erste Drehteil (121) ferner einen fünften bogenförmigen Arm (1213) aufweist und der fünfte bogenförmige Arm (1213) in dem ersten bogenförmigen Schlitz (111) gleitfähig angeordnet ist, wobei sich die erste bogenförmige Zusatzoberfläche (12131) an einer Außenoberfläche des fünften bogenförmigen Arms (1213) befindet und sich die zweite bogenförmige Zusatzoberfläche (1113) an der Innenwand des ersten bogenförmigen Schlitzes (111) befindet; und
das zweite Drehteil (131) ferner einen sechsten bogenförmigen Arm (1313) aufweist und der sechste bogenförmige Arm (1313) in dem dritten bogenförmigen Schlitz (1113) gleitfähig angeordnet ist, wobei sich die dritte bogenförmige Zusatzoberfläche (13131) an einer Außenoberfläche des sechsten bogenförmigen Arms (1313) befindet und sich die vierte bogenförmige Zusatzoberfläche (1114) an der Innenwand des dritten bogenförmigen Schlitzes (1113) befindet.

5. Scharnier (10) nach Anspruch 3 oder 4, wobei das erste Drehteil (121) eine erste Druckfläche (1212) aufweist und die erste eingebettete Welle (122) eine zweite Druckfläche (1223) aufweist; wobei
das erste Drehteil (121) verwendet wird, um die erste eingebettete Welle (122) anzutreiben, damit sie in einer Richtung des Lösens von dem ersten bogenförmigen Schlitz (111) gleitet, wenn die erste Druckfläche (1212) gegen die zweite Druckfläche (1223) drückt;
das zweite Drehteil (131) ferner eine dritte Druckfläche (1312) aufweist und die zweite eingebettete Welle (132) eine vierte Druckfläche (1323) aufweist; und
das zweite Drehteil (131) verwendet wird, um die zweite eingebettete Welle (132) anzutreiben, damit sie in einer Richtung des Lösens von dem dritten bogenförmigen Schlitz (1113) gleitet, wenn die dritte Druckfläche (1312) gegen die vierte Druckfläche (1323) drückt.

6. Scharnier (10) nach einem der Ansprüche 3 bis 5, wobei ein Querschnitt der ersten eingebetteten Welle (122) in einer Richtung senkrecht zu einer Tangente der zweiten bogenförmigen Oberfläche (12211) eine I-Form aufweist;
die erste eingebettete Welle (122) zwei zweite bogenförmige Oberflächen (12211) aufweist und wobei sich die zwei zweiten bogenförmigen Oberflächen (12211) jeweils an zwei gegenüberliegenden Oberflächen der ersten eingebetteten Welle (122) befinden;
die erste eingebettete Welle (122) zwei zweite bogenförmige Schlitze (1222) aufweist und wobei sich die zwei zweiten bogenförmigen Schlitze (1222) jeweils auf zwei gegenüberliegenden Seiten der ersten eingebetteten Welle (122) befinden;
ein Querschnitt der zweiten eingebetteten Welle (132) in einer Richtung senkrecht zu einer Tangente der vierten bogenförmigen Oberfläche (12221) eine I-Form aufweist; die zweite eingebettete Welle (132) zwei vierte bogenförmige Oberflächen (12221) aufweist und wobei sich die zwei vierten bogenförmigen Oberflächen (12221) jeweils an zwei gegenüberliegenden Oberflächen der zweiten eingebetteten Welle (132) befinden; und
die zweite eingebettete Welle (132) zwei vierte bogenförmige Schlitze (1322) aufweist und wobei sich die zwei vierten bogenförmigen Schlitze (1322) jeweils auf zwei gegenüberliegenden Seiten der zweiten eingebetteten Welle (132) befinden.

7. Scharnier (10) nach Anspruch 6, wobei das erste Drehteil (121) zwei zweite bogenförmige Arme (1211) aufweist, wobei die zwei zweiten bogenförmigen Arme (1211) einander gegenüberliegend angeordnet sind und die erste eingebettete Welle (122) zwischen die zwei zweiten bogenförmigen Arme (1211) geklemmt ist; und das zweite Drehteil (131) zwei vierte bogenförmige Arme (1311) aufweist, wobei die zwei vierten bogenförmigen Arme (1311) einander gegenüberliegend angeordnet sind und wobei die zweite eingebettete Welle (132) zwischen die zwei vierten bogenförmigen Arme (1311) geklemmt ist.

8. Scharnier (10) nach Anspruch 5, wobei der fünfte bogenförmige Arm (1213) einen ersten vorstehenden Teil (12120) aufweist, der in einer Axialrichtung des fünften bogenförmigen Arms (1213) verläuft, die erste eingebettete Welle (122) einen zweiten vorstehenden Teil (12230) aufweist, der in einer Axialrichtung der ersten eingebetteten Welle (122) verläuft, wobei sich die erste Druckfläche (1212) an einer Seitenfläche, die von dem ersten vorstehenden Teil (12120) ist und die dem zweiten vorstehenden Teil (12230) zugewandt ist, befindet und wobei sich die zweite Druckfläche (1223) an einer Seitenfläche, die von dem zweiten vorstehenden Teil (12230) ist und die dem ersten vorstehenden Teil (12120) zugewandt ist, befindet; und
der sechste bogenförmige Arm (1313) einen dritten vorstehenden Teil (13120) aufweist, der in einer Axialrichtung des sechsten bogenförmigen Arms (1313) verläuft, wobei die zweite eingebettete Welle (132) einen vierten vorstehenden Teil (13230) aufweist, der in einer Axialrichtung der zweiten eingebetteten Welle (132) verläuft, wobei sich die dritte Druckfläche (1312) an einer Seitenfläche, die von dem dritten vorstehenden Teil (13120) ist und die dem vierten vorstehenden Teil (13230) zugewandt ist, befindet und wobei sich die vierte Druckfläche (1323) an einer Seitenfläche, die von dem vierten vorstehenden Teil (13230) ist und die dem dritten vorstehenden Teil (13120) zugewandt ist, befindet.

9. Scharnier (10) nach einem der Ansprüche 3 bis 8, wobei die Hauptwelle (11) eine erste Begrenzungsfläche (112) aufweist, die erste eingebettete Welle (122) eine zweite Begrenzungsfläche (1224) aufweist und verhindert wird, dass die erste eingebettete Welle (122) in der Richtung des Lösens von dem ersten bogenförmigen Schlitz (111) gleitet, wenn die erste Begrenzungsfläche (112) gegen die zweite Begrenzungsfläche (1224) drückt; und
die Hauptwelle (11) eine dritte Begrenzungsfläche (114) aufweist, die zweite eingebettete Welle (132) eine vierte Begrenzungsfläche (1324) aufweist und verhindert wird, dass die zweite eingebettete Welle (132) in der Richtung des Lösens von dem dritten bogenförmigen Schlitz (1113) gleitet, wenn die dritte Begrenzungsfläche (114) gegen die vierte Begrenzungsfläche (1324) drückt.

10. Scharnier (10) nach Anspruch 9, wobei die zweite bogenförmige Oberfläche (12211) der ersten eingebetteten Welle (122) einen ersten konkaven Teil (12240) aufweist, wobei sich die zweite Begrenzungsfläche (1224) an einer Innenwand, die von dem ersten konkaven Teil (12240) ist und die einer Öffnung des ersten bogenförmigen Schlitzes (111) zugewandt ist, befindet, wobei die erste bogenförmige Oberfläche (1111) einen ersten Vorsprung (1120) aufweist, der in den ersten konkaven Teil (12240) verläuft, und wobei sich die erste Begrenzungsfläche (112) an einer Seitenwand, die von dem ersten Vorsprung (1120) ist und die der zweiten Begrenzungsfläche (1224) zugewandt ist, befindet; und
wobei die sechste bogenförmige Oberfläche (13211) der zweiten eingebetteten Welle (132) einen zweiten konkaven Teil (13240) aufweist, wobei sich die vierte Begrenzungsfläche (1324) an einer Innenwand, die von dem zweiten konkaven Teil (13240) ist und die einer Öffnung des dritten bogenförmige Schlitzes (1113) zugewandt ist, befindet, wobei die fünfte bogenförmige Oberfläche (1131) einen zweiten Vorsprung (1140) aufweist, der in den zweiten konkaven Teil (13240) verläuft, und wobei sich die dritte Begrenzungsfläche (114) an einer Seitenwand, die von dem zweiten Vorsprung (1140) ist und die der vierten Begrenzungsfläche (1324) zugewandt ist, befindet.

11. Scharnier (10) nach einem der Ansprüche 1 bis 10, wobei die Hauptwelle (11) eine Stützfläche zum Stützen einer flexiblen Anzeige aufweist und wobei die Stützfläche U-förmig oder elliptisch ist.

12. Scharnier (10) nach Anspruch 11, wobei die konkaven Oberflächen der ersten bogenförmigen Oberfläche (1111), der zweiten bogenförmigen Oberfläche (12211), der dritten bogenförmigen Oberfläche (12111), der vierten bogenförmigen Oberfläche (12221), der fünften bogenförmigen Oberfläche (1131), der sechsten bogenförmigen Oberfläche (13211), der siebenten bogenförmigen Oberfläche (13111) und der achten bogenförmigen Oberfläche (13221) alle der flexiblen Anzeige zugewandt angeordnet sind; und
wobei das erste Drehteil (121) eine erste Stützfläche (1215) zum Stützen der flexiblen Anzeige aufweist, das zweite Drehteil (131) eine zweite Stützfläche (1315) zum Stützen der flexiblen Anzeige aufweist und wobei sich sowohl die erste Stützfläche (1215) als auch die zweite Stützfläche (1315) in einer selben Ebene befinden und ein Abstand zwischen der Stützfläche und einer hinteren Oberfläche der flexiblen Anzeige größer als die Abstände zwischen der ersten Stützfläche (1215) und der zweiten Stützfläche (1315) und der hinteren Oberfläche der flexiblen Anzeige ist, wenn das Scharnier (10) in einem aufgeklappten Zustand ist.

13. Scharnier (10) nach einem der Ansprüche 1 bis 12, wobei das Scharnier (10) ferner eine Synchronisationskomponente (14) umfasst und wobei die Synchronisationskomponente (14) ein erstes Synchronisationsteil (141) und ein zweites Synchronisationsteil (142) umfasst; wobei
ein Ende des ersten Synchronisationsteils (141) mit dem ersten Drehteil (121) gleitfähig verbunden ist, das andere Ende des ersten Synchronisationsteils (141) mit der Hauptwelle (11) drehbar verbunden ist und ein Drehachsenmittelpunkt des ersten Synchronisationsteils (141) zu einem Drehachsenmittelpunkt des ersten Drehteils (121) parallel ist;
ein Ende des zweiten Synchronisationsteils (142) mit dem zweiten Drehteil (131) gleitfähig verbunden ist, das andere Ende des zweiten Synchronisationsteils (142) mit der Hauptwelle (11) drehbar verbunden ist und ein Drehachsenmittelpunkt des zweiten Synchronisationsteils (142) zu einem Drehachsenmittelpunkt des zweiten Drehteils (131) parallel ist; und
das erste Synchronisationsteil (141) einen ersten Zahnradteil (1411) aufweist, das zweite Synchronisationsteil (142) einen zweiten Zahnradteil (1421) aufweist und der erste Zahnradteil (1411) mit dem zweiten Zahnradteil (1421) in Getriebeverbindung ist.

14. Klappbare Vorrichtung, die ein erstes Gehäuse, ein zweites Gehäuse und eine flexible Anzeige umfasst und die ferner das Scharnier (10) nach einem der Ansprüche 1 bis 13 umfasst, wobei
das erste Gehäuse an dem ersten Drehteil (121) befestigt ist und das zweite Gehäuse an dem zweiten Drehteil (131) befestigt ist; und
ein erster Teil der flexiblen Anzeige mit dem ersten Gehäuse verbunden ist und ein zweiter Teil der flexiblen Anzeige an dem zweiten Gehäuse befestigt ist.

15. Klappbare Vorrichtung nach Anspruch 14, wobei ein Abstand zwischen einer neutralen Schicht der flexiblen Anzeige und sowohl einem Drehachsenmittelpunkt des ersten Drehteils (121) und der ersten eingebetteten Welle (122) als auch einem Drehachsenmittelpunkt des zweiten Drehteils (131) und der zweiten eingebetteten Welle (132) kleiner oder gleich 1 mm ist.

## Revendications

1. Charnière (10) destinée à un dispositif pliable, comprenant un arbre principal (11), un premier composant de pliage (12), et un deuxième composant de pliage (13), dans laquelle le premier composant de pliage (12) et le deuxième composant de pliage (13) sont disposés de part et d'autre de l'arbre principal (11) ;
le premier composant de pliage (12) comprend une première partie rotative (121) et un premier arbre emboîté (122) ;
l'arbre principal (11) présente une première surface en forme d'arc (1111), le premier arbre emboîté (122) présente une deuxième surface en forme d'arc (12211), et la première surface en forme d'arc (1111) est en contact avec la deuxième surface en forme d'arc (12211) ;
la première partie rotative (121) présente une troisième surface en forme d'arc (12111), le premier arbre emboîté (122) présente une quatrième surface en forme d'arc (12221), et la troisième surface en forme d'arc (12111) est en contact avec la quatrième surface en forme d'arc (12221) ;
un centre d'axe de la première surface en forme d'arc (1111), un centre d'axe de la deuxième surface en forme d'arc (12211), un centre d'axe de la troisième surface en forme d'arc (12111), et un centre d'axe de la quatrième surface en forme d'arc (12221) coïncident tous entre eux ;
le deuxième composant de pliage (13) comprend une deuxième partie rotative (131) et un deuxième arbre emboîté (132) ;
l'arbre principal (11) présente une cinquième surface en forme d'arc (1131), le deuxième arbre emboîté (132) présente une sixième surface en forme d'arc (13211), et la cinquième surface en forme d'arc (1131) est en contact avec la sixième surface en forme d'arc (13211) ;
la deuxième partie rotative (131) présente une septième surface en forme d'arc (13111), le deuxième arbre emboîté (132) présente une huitième surface en forme d'arc (13221), et la septième surface en forme d'arc (13111) est en contact avec la huitième surface en forme d'arc (13221) ; et
un centre d'axe de la cinquième surface en forme d'arc (1131), un centre d'axe de la sixième surface en forme d'arc (13211), un centre d'axe de la septième surface en forme d'arc (13111), et un centre d'axe de la huitième surface en forme d'arc (13221) coïncident tous entre eux.

2. Charnière (10) selon la revendication 1, dans laquelle la première partie rotative (121) présente une première surface auxiliaire en forme d'arc (12131), l'arbre principal (11) présente une deuxième surface auxiliaire en forme d'arc (1113), la première surface auxiliaire en forme d'arc (12131) est en contact avec la deuxième surface auxiliaire en forme d'arc (1113), et un centre d'axe de la première surface auxiliaire en forme d'arc (12131), le centre d'axe de la première surface en forme d'arc (1111), et un centre d'axe de la deuxième surface auxiliaire en forme d'arc (1113) coïncident tous entre eux ; et
la deuxième partie rotative (131) présente une troisième surface auxiliaire en forme d'arc (13131), l'arbre principal (11) présente une quatrième surface auxiliaire en forme d'arc (1114), la troisième surface auxiliaire en forme d'arc (13131) est en contact avec la quatrième surface auxiliaire en forme d'arc (1114), et un centre d'axe de la troisième surface auxiliaire en forme d'arc (13131), le centre d'axe de la troisième surface en forme d'arc (12111), et un centre d'axe de la quatrième surface auxiliaire en forme d'arc (1114) coïncident tous entre eux.

3. Charnière (10) selon la revendication 1 ou 2, dans laquelle l'arbre principal (11) présente une première encoche en forme d'arc (111), le premier arbre emboîté (122) présente un premier bras en forme d'arc (1221), et le premier bras en forme d'arc (1221) est disposé de manière coulissante dans la première encoche en forme d'arc (111), la première surface en forme d'arc (1111) étant située sur une paroi intérieure de la première encoche en forme d'arc (111), et la deuxième surface en forme d'arc (12211) étant située sur une surface extérieure du premier bras en forme d'arc (1221) ; la première partie rotative (121) présente un deuxième bras en forme d'arc (1211), le premier arbre emboîté (122) présente en outre une deuxième encoche en forme d'arc (1222), et le deuxième bras en forme d'arc (1211) est disposé de manière coulissante dans la deuxième encoche en forme d'arc (1222), la troisième surface en forme d'arc (12111) étant située sur une surface extérieure du deuxième bras en forme d'arc (1211), et la quatrième surface en forme d'arc (12221) étant située sur une paroi intérieure de la deuxième encoche en forme d'arc (1222) ;
l'arbre principal (11) présente en outre une troisième encoche en forme d'arc (1113), le deuxième arbre emboîté (132) présente un troisième bras en forme d'arc (1321), et le troisième bras en forme d'arc (1321) est disposé de manière coulissante dans la troisième encoche en forme d'arc (1113), la cinquième surface en forme d'arc (1131) étant située sur une paroi intérieure de la troisième encoche en forme d'arc (1113), et la sixième surface en forme d'arc (13211) étant située sur une surface extérieure du troisième bras en forme d'arc (1321) ; et
la deuxième partie rotative (131) présente un quatrième bras en forme d'arc (1311), le deuxième arbre emboîté (132) présente en outre une quatrième encoche en forme d'arc (1322), et le quatrième bras en forme d'arc (1311) est disposé de manière coulissante dans la quatrième encoche en forme d'arc (1322), la septième surface en forme d'arc (13111) étant située sur une surface extérieure du quatrième bras en forme d'arc (1311), et la huitième surface en forme d'arc (13221) étant située sur une paroi intérieure de la quatrième encoche en forme d'arc (1322).

4. Charnière (10) selon la revendication 3, dans laquelle la première partie rotative (121) présente en outre un cinquième bras en forme d'arc (1213), et le cinquième bras en forme d'arc (1213) est disposé de manière coulissante dans la première encoche en forme d'arc (111), la première surface auxiliaire en forme d'arc (12131) étant située sur une surface extérieure du cinquième bras en forme d'arc (1213), et la deuxième surface auxiliaire en forme d'arc (1113) étant située sur la paroi intérieure de la première encoche en forme d'arc (111) ; et
la deuxième partie rotative (131) présente en outre un sixième bras en forme d'arc (1313), et le sixième bras en forme d'arc (1313) est disposé de manière coulissante dans la troisième encoche en forme d'arc (1113), la troisième surface auxiliaire en forme d'arc (13131) étant située sur une surface extérieure du sixième bras en forme d'arc (1313), et la quatrième surface auxiliaire en forme d'arc (1114) étant située sur la paroi intérieure de la troisième encoche en forme d'arc (1113).

5. Charnière (10) selon la revendication 3 ou 4, dans laquelle la première partie rotative (121) présente une première surface d'appui (1212), et le premier arbre emboîté (122) présente une deuxième surface d'appui (1223) ;
lorsque la première surface d'appui (1212) est en appui contre la deuxième surface d'appui (1223), la première partie rotative (121) est utilisée pour entraîner le coulissement du premier arbre emboîté (122) dans une direction de détachement par rapport à la première encoche en forme d'arc (111) ;
la deuxième partie rotative (131) présente en outre une troisième surface d'appui (1312), et le deuxième arbre emboîté (132) présente une quatrième surface d'appui (1323) ; et
lorsque la troisième surface d'appui (1312) est en appui contre la quatrième surface d'appui (1323), la deuxième partie rotative (131) est utilisée pour entraîner le coulissement du deuxième arbre emboîté (132) dans une direction de détachement par rapport à la troisième encoche en forme d'arc (1113).

6. Charnière (10) selon l'une quelconque des revendications 3 à 5, dans laquelle, dans une direction perpendiculaire à une tangente de la deuxième surface en forme d'arc (12211), une section transversale du premier arbre emboîté (122) est en forme de I ; le premier arbre emboîté (122) présente deux deuxièmes surfaces en forme d'arc (12211), et les deux deuxièmes surfaces en forme d'arc (12211) sont situées respectivement sur deux surfaces opposées du premier arbre emboîté (122) ;
le premier arbre emboîté (122) présente deux deuxièmes encoches en forme d'arc (1222), et les deux deuxièmes encoches en forme d'arc (1222) sont situées respectivement sur deux côtés opposés du premier arbre emboîté (122) ;
dans une direction perpendiculaire à une tangente de la quatrième surface en forme d'arc (12221), une section transversale du deuxième arbre emboîté (132) est en forme de I ;
le deuxième arbre emboîté (132) présente deux quatrièmes surfaces en forme d'arc (12221), et les deux quatrièmes surfaces en forme d'arc (12221) sont situées respectivement sur deux surfaces opposées du deuxième arbre emboîté (132) ; et
le deuxième arbre emboîté (132) présente deux quatrièmes encoches en forme d'arc (1322), et les deux quatrièmes encoches en forme d'arc (1322) sont situées respectivement sur deux côtés opposés du deuxième arbre emboîté (132).

7. Charnière (10) selon la revendication 6, dans laquelle la première partie rotative (121) présente deux deuxièmes bras en forme d'arc (1211), les deux deuxièmes bras en forme d'arc (1211) sont disposés l'un en face de l'autre, et le premier arbre emboîté (122) est serré entre les deux deuxièmes bras en forme d'arc (1211) ; et
la deuxième partie rotative (131) présente deux quatrièmes bras en forme d'arc (1311), les deux quatrièmes bras en forme d'arc (1311) sont disposés l'un en face de l'autre, et le deuxième arbre emboîté (132) est serré entre les deux quatrièmes bras en forme d'arc (1311).

8. Charnière (10) selon la revendication 5, dans laquelle le cinquième bras en forme d'arc (1213) présente une première partie saillante (12120) s'étendant dans une direction axiale du cinquième bras en forme d'arc (1213), le premier arbre emboîté (122) présente une deuxième partie saillante (12230) s'étendant dans une direction axiale du premier arbre emboîté (122), la première surface d'appui (1212) est située sur une surface latérale de la première partie saillante (12120) qui fait face à la deuxième partie saillante (12230), et la deuxième surface d'appui (1223) est située sur une surface latérale de la deuxième partie saillante (12230) qui fait face à la première partie saillante (12120) ; et
le sixième bras en forme d'arc (1313) présente une troisième partie saillante (13120) s'étendant dans une direction axiale du sixième bras en forme d'arc (1313), le deuxième arbre emboîté (132) présente une quatrième partie saillante (13230) s'étendant dans une direction axiale du deuxième arbre emboîté (132), la troisième surface d'appui (1312) est située sur une surface latérale de la troisième partie saillante (13120) qui fait face à la quatrième partie saillante (13230), et la quatrième surface d'appui (1323) est située sur une surface latérale de la quatrième partie saillante (13230) qui fait face à la troisième partie saillante (13120).

9. Charnière (10) selon l'une quelconque des revendications 3 à 8, dans laquelle l'arbre principal (11) présente une première surface de limitation (112), le premier arbre emboîté (122) présente une deuxième surface de limitation (1224), et lorsque la première surface de limitation (112) est en appui contre la deuxième surface de limitation (1224), le premier arbre emboîté (122) est empêché de coulisser dans la direction de détachement par rapport à la première encoche en forme d'arc (111) ; et l'arbre principal (11) présente une troisième surface de limitation (114), le deuxième arbre emboîté (132) présente une quatrième surface de limitation (1324), et lorsque la troisième surface de limitation (114) est en appui contre la quatrième surface de limitation (1324), le deuxième arbre emboîté (132) est empêché de coulisser dans la direction de détachement par rapport à la troisième encoche en forme d'arc (1113).

10. Charnière (10) selon la revendication 9, dans laquelle la deuxième surface en forme d'arc (12211) du premier arbre emboîté (122) présente une première partie concave (12240), la deuxième surface de limitation (1224) est située sur une paroi intérieure de la première partie concave (12240) qui fait face à une ouverture de la première encoche en forme d'arc (111), la première surface en forme d'arc (1111) présente une première saillie (1120) s' étendant jusque dans la première partie concave (12240), et la première surface de limitation (112) est située sur une paroi latérale de la première saillie (1120) qui fait face à la deuxième surface de limitation (1224) ; et
la sixième surface en forme d'arc (13211) du deuxième arbre emboîté (132) présente une deuxième partie concave (13240), la quatrième surface de limitation (1324) est située sur une paroi intérieure de la deuxième partie concave (13240) qui fait face à une ouverture de la troisième encoche en forme d'arc (1113), la cinquième surface en forme d'arc (1131) présente une deuxième saillie (1140) s'étendant jusque dans la deuxième partie concave (13240), et la troisième surface de limitation (114) est située sur une paroi latérale de la deuxième saillie (1140) qui fait face à la quatrième surface de limitation (1324).

11. Charnière (10) selon l'une quelconque des revendications 1 à 10, dans laquelle l'arbre principal (11) présente une surface de support pour supporter un affichage flexible, et la surface de support est en forme de U ou elliptique.

12. Charnière (10) selon la revendication 11, dans laquelle des surfaces concaves de la première surface en forme d'arc (1111), de la deuxième surface en forme d'arc (12211), de la troisième surface en forme d'arc (12111), de la quatrième surface en forme d'arc (12221), de la cinquième surface en forme d'arc (1131), de la sixième surface en forme d'arc (13211), de la septième surface en forme d'arc (13111), et de la huitième surface en forme d'arc (13221) sont toutes disposées face à l'affichage flexible ; et
dans laquelle la première partie rotative (121) présente une première surface de support (1215) pour supporter l'affichage flexible, la deuxième partie rotative (131) présente une deuxième surface de support (1315) pour supporter l'affichage flexible, et lorsque la charnière (10) est dans un état déplié, la première surface de support (1215) et la deuxième surface de support (1315) se situent toutes deux dans un même plan, et une distance entre la surface de support et une surface arrière de l'affichage flexible est supérieure à des distances entre la première surface de support (1215) et la deuxième surface de support (1315), et la surface arrière de l'affichage flexible.

13. Charnière (10) selon l'une quelconque des revendications 1 à 12, la charnière (10) comprenant en outre un composant de synchronisation (14), et le composant de synchronisation (14) comprenant une première partie de synchronisation (141) et une deuxième partie de synchronisation (142) ;
une extrémité de la première partie de synchronisation (141) étant reliée de manière coulissante à la première partie rotative (121), l'autre extrémité de la première partie de synchronisation (141) étant reliée de manière rotative à l'arbre principal (11), et un centre d'axe de rotation de la première partie de synchronisation (141) étant parallèle à un centre d'axe de rotation de la première partie rotative (121) ;
une extrémité de la deuxième partie de synchronisation (142) étant reliée de manière coulissante à la deuxième partie rotative (131), l'autre extrémité de la deuxième partie de synchronisation (142) étant reliée de manière rotative à l'arbre principal (11), et un centre d'axe de rotation de la deuxième partie de synchronisation (142) étant parallèle à un centre d'axe de rotation de la deuxième partie rotative (131) ; et
la première partie de synchronisation (141) présentant une première partie à denture (1411), la deuxième partie de synchronisation (142) présentant une deuxième partie à denture (1421), et la première partie à denture (1411) étant en liaison de transmission avec la deuxième partie à denture (1421).

14. Dispositif pliable, comprenant un premier boîtier, un deuxième boîtier, et un affichage flexible, et comprenant en outre la charnière (10) selon l'une quelconque des revendications 1 à 13, dans lequel
le premier boîtier est fixé à la première partie rotative (121), et le deuxième boîtier est fixé à la deuxième partie rotative (131) ; et
une première partie de l'affichage flexible est reliée au premier boîtier, et une deuxième partie de l'affichage flexible est fixée au deuxième boîtier.

15. Dispositif pliable selon la revendication 14, dans lequel une distance entre une couche neutre de l'affichage flexible et chacun d'un centre d'axe de rotation de la première partie rotative (121) et du premier arbre emboîté (122) et d'un centre d'axe de rotation de la deuxième partie rotative (131) et du deuxième arbre emboîté (132) est inférieure ou égale à 1 mm.
